# EUROPEAN PATENT APPLICATION

(11) **EP 4 709 048 A1**
(43) Date of publication of application: **11.03.2026**
(21) Application number: 24868631.3
(22) Date of filing: 13.09.2024
(51) Int. Cl.: H05B 6/12, H05B 6/06, F24C 15/10, F24C 7/08, F24C 7/06, F24C 15/34, F24C 3/12

(54) **COOKING APPARATUS**

(30) Priority: 21.09.2023 KR 20230126657; 21.09.2023 KR 20230126658; 26.09.2023 KR 20230129155; 22.02.2024 KR 20240026117; 25.07.2024 KR 20240098759
(71) Applicant: LG Electronics Inc., Yeongdeungpo-gu Seoul 07336 (KR)
(72) Inventor: LEE, Jae-Woo, Seoul 08592 (KR); OH, Dooyong, Seoul 08592 (KR); KANG, Kyelyong, Seoul 08592 (KR); HONG, Jaepyo, Seoul 08592 (KR); CHA, Kwanghyung, Seoul 08592 (KR); LEE, Yongsoo, Seoul 08592 (KR)
(74) Representative: Vossius & Partner Patentanwälte Rechtsanwälte mbB
(86) International application number: PCT/KR2024/014012
(87) International publication number: WO 2025/063654

(57) **Abstract**

The present invention relates to a cooking apparatus in which a central inner area, in which a working coil pattern is not formed, is formed inside a burner, and a dummy via hole or dummy pattern electrically separated from the working coil pattern is arranged in the central inner area, and thus the possibility of damage to the working coil pattern due to heat concentration in the working coil pattern and the possibility of eddy current loss can be minimized, and heat deformation of a coil circuit board module due to heat generation in the central inner area can be effectively prevented.

## Description

### [Technical Field]

The present disclosure relates to a cooking appliance, and more specifically, to a cooking appliance in which a central inner area in which a working coil pattern is not formed is defined inside a burner and a dummy via hole or a dummy pattern is formed in the central inner area in a state of being electrically insulated from the working coil pattern, thereby minimizing a possibility of damage to the working coil pattern and a possibility of occurrence of eddy current loss due to heat generation concentration on the working coil pattern, and effectively preventing thermal deformation of a coil circuit board module due to heat generation in the central inner area.

### [Background Art]

A cooking appliance is one of home appliances for cooking food, and is installed in a kitchen space to cook food according to a user's intention. Such cooking appliances may be classified in various ways based on a used heat source, a form, and a type of used fuel.

When the cooking appliances are classified based on the type of cooking food, the cooking appliances may be classified into an open type cooking appliance and a closed type cooking appliance based on a form of a space in which the food is placed. The closed type cooking appliance may include an oven and a microwave, and the open type cooking appliance may include a cooktop and a hop.

The cooktop as the open type cooking appliance may be configured to heat a cooking target contained in a cooking container using at least one burner.

The cooktop may be provided in a form of having a burner that uses electricity, or may be provided in a form of having a burner that uses gas.

In addition, the cooktop may be implemented alone. The cooking appliance may be implemented in a form of an oven range including an oven under the cooktop.

An example of the cooktop having the burner using electricity is an induction heating cooking appliance.

The induction heating cooking appliance is a cooking appliance that performs a cooking function in an induction heating manner. In the induction heating cooking appliance, when high-frequency power is applied to a working coil, a magnetic field may be generated around the working coil.

An eddy current is generated in the cooking container made of a magnetic material under the generated magnetic field, and the food cooking may be performed by the cooking container which acts as a resistor against the eddy current and generates heat.

Such an induction heating cooking appliance does not require combustion of gas and thus does not generate combustion exhaust gas. In addition, the induction heating cooking appliance immediately generates heat in the container itself, thereby minimizing a transfer process via radiation or conduction of heat and thus heating the food at a high speed.

In a conventional induction heating type cooktop, a working coil is formed by twisting a plurality of Litz wires, and an individual burner is formed by winding the working coil in a spiral shape multiple times so as to have a multi-multi-layer structure.

In this regard, a coil frame for maintaining and supporting a winding shape of the working coil should be necessarily provided in each burner.

Therefore, a vertical size of the individual burner as a sum of a vertical size of the working coil wound in the multi-layer structure and a vertical size of the coil frame amounts to a significantly greater percentage of an entire vertical size of the cooktop.

Due to the limitation of the size of the individual burner constituting the cooktop, the conventional cooktop has no choice but to have a limitation in increasing an output of the individual burner.

In addition, in configuring the cooktop having a plurality of burners, a space in which other components or parts are installed in the conventional cooktop is very limited, and accordingly, a total number of burners capable of being provided in the cooktop is very limited.

In an alternative to the Ritz wire-type working coil, a technology related to a cooktop in which a burner is formed by forming the working coil in a spiral multilayer pattern on a printed circuit board has been developed. (Prior Document 001, Design and Optimization of Small Inductors on Extra-Thin PCB for Flexible Cooking Surfaces/IEEE TRANSACTIONS ON INDUSTRY APPLICATIONS, VOL. 53, NO. 1, JANUARY/FEBRUARY 2017)

The cooktop disclosed in the prior document 001 may be configured such that the burner is formed by forming a working coil pattern wound in a spiral shape in a single layer or a plurality of layers on a single printed circuit board.

The cooktop disclosed in the prior art document 001 as described above may have an advantage in that the working coil patterns constituting the burner are integrally formed with each other on a single printed circuit board such that a vertical size of the cooktop may be significantly reduced compared to a conventional cooktop, thereby improving the vertical space utilization, and the number of burners may be significantly increased compared to the conventional cooktop, thereby improving the horizontal space utilization.

### [Disclosure]

### [Technical Problem]

The cooktop disclosed in the prior art document 001 has a problem in that a working coil pattern constituting an individual burner is spirally wound, such that heat generation of an individual pattern is concentrated on a central inner area of the working coil, and thus the highest temperature distribution occurs in the central inner area.

Accordingly, the cooktop disclosed in the prior art document 001 has a problem in that the working coil pattern formed in the central inner area of the burner is highly likely to be damaged due to such a temperature deviation.

In addition, the cooktop disclosed in the prior art document 001 has a problem in that eddy current loss of the working coil pattern formed in the central inner area of the burner may be great due to such heat generation concentration.

In addition, the cooktop disclosed in the prior art document 001 has a problem in that when an area in which the working coil pattern is not formed is generated in the central inner area of the burner, the generated area is filled only with an insulating material (Prepreg) containing glass fiber, and thus in the central inner area, thermal deformation is highly likely to occur due to heat generation of the working coil pattern.

In addition, the cooktop disclosed in the prior art document 001 has a problem in that as the working coil pattern is not formed in the central inner area of the burner, the central inner area is filled with only the electrical insulating material (Prepreg), such that a manufacturing cost is increased.

The present disclosure has been devised to solve the problems of the prior art. Thus, a first purpose of the present disclosure is to provide a cooking appliance in which a central inner area in which the working coil pattern is not formed is defined inside the burner, thereby minimizing a possibility of damage to the working coil pattern and a possibility of occurrence of eddy current loss due to heat generation concentration of the working coil pattern.

In addition, a second purpose of the present disclosure is to provide a cooking appliance in which a dummy via hole or a dummy pattern is formed in the central inner area in which the working coil pattern is not formed so as to be electrically insulated from the working coil pattern, thereby effectively preventing thermal deformation of a coil circuit board module due to heat generation in the central inner area.

In addition, a third purpose of the present disclosure is to provide a cooking appliance in which a dummy via hole or a dummy pattern is formed in the central inner area in which the working coil pattern is not formed so as to be electrically insulated from the working coil pattern, thereby increasing rigidity in the central inner area of the burner and reducing a proportion of an insulating material to reduce a manufacturing cost.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

### [Technical Solution]

The cooking appliance according to the present disclosure includes a top plate on which a container may be seated; and a heater configured to receive electric power to generate a magnetic field to heat the container, wherein the heater includes a coil circuit board module including a working coil pattern generating the magnetic field, wherein the coil circuit board module further includes a dummy via hole or a dummy pattern formed therein, wherein the dummy via hole or the dummy pattern may be electrically insulated from the working coil pattern.

Moreover, the coil circuit board module may further include a sensing coil pattern for sensing whether the container is seated, wherein each of the dummy via hole and the dummy pattern may be positioned so as to be electrically insulated from the sensing coil pattern.

Moreover, a central inner area may be defined inwardly of the working coil pattern in a horizontal direction, wherein the dummy via hole and the dummy pattern may be positioned to be within the central inner area when viewed from the top plate.

Moreover, the working coil pattern may be wound spirally to form a plurality of turns, wherein an inter-turn area may be defined between turns constituting the working coil pattern and disposed adjacent to each other in a horizontal direction, wherein the dummy via hole and the dummy pattern may be disposed to be within the inter-turn area when viewed from the top plate.

Moreover, the working coil pattern may include a plurality of working coil patterns, wherein an inter-coil area may be defined between the working coil patterns adjacent to each other in a horizontal direction among the plurality of working coil patterns, wherein the dummy via hole and the dummy pattern may be disposed to be within the inter-coil area when viewed from the top plate.

Moreover, the dummy via hole may include a plurality of dummy via holes, wherein the plurality of dummy via holes may be arranged in a lattice shape when viewed from the top plate.

Moreover, the lattice shape may be a quadrilateral lattice shape or a hexagonal lattice shape.

Moreover, each of the plurality of dummy via holes may include: a top pad formed in an upper surface of the coil circuit board module; and a bottom pad electrically connected to the top pad and formed in a lower end surface of the coil circuit board module, wherein a horizontal spacing between centers of a pair of via holes adjacent to each other among the plurality of dummy via holes may be greater than each of an outer diameter of the top pad and an outer diameter of the bottom pad.

Moreover, the dummy via hole may extend along a through-hole extending through the coil circuit board module in a vertical direction from an upper end surface of the coil circuit board module to a lower end surface of the coil circuit board module.

Moreover, the dummy via hole may include: a top pad formed in an upper surface of the coil circuit board module; a bottom pad formed in a lower end surface of the coil circuit board module; and an inner conductor electrically connecting the top pad and the bottom pad to each other and extending along the through-hole.

Moreover, the dummy via hole may be formed in a hollow state from the top pad to the bottom pad.

Moreover, the dummy via hole may be formed in a solid state from the top pad to the bottom pad.

Moreover, the dummy via hole may be formed in a state in which at least one of the top pad or the bottom pad closes the through-hole.

Moreover, the dummy pattern may extend in a direction parallel to a winding direction of the working coil pattern or in a direction intersecting the winding direction of the working coil pattern.

Moreover, the dummy pattern may include a plurality of dummy patterns, wherein the plurality of dummy patterns may be arranged so as to be spaced from each other.

Moreover, the coil circuit board module may include a plurality of working coil patterns arranged in a plurality of layered structures, and the plurality of layered structures may be integrally formed with each other.

Moreover, the dummy pattern may include a plurality of dummy patterns, wherein at least some of the plurality of dummy patterns may be disposed in an upper end surface or a lower end surface of the coil circuit board module.

Moreover, the coil circuit board module may include a plurality of working coil patterns arranged in a plurality of layered structures along a vertical direction, wherein the others of the plurality of dummy patterns may be disposed in an inner layer of the plurality of layered structures.

Moreover, both the dummy via hole and the dummy pattern may be disposed in the coil circuit board module, wherein one end or the other end of the dummy pattern may be connected to the dummy via hole.

A home appliance according to the present disclosure includes a top plate with which an object is in contact; and a coil circuit board module disposed under the top plate and including a working coil pattern for heating the object, wherein the coil circuit board module further includes a dummy metal portion electrically insulated from the working coil pattern.

### [Advantageous Effects]

According to the present disclosure, the central inner area in which the working coil pattern is not formed is defined inside the burner, thereby minimizing a possibility of damage to the working coil pattern and a possibility of occurrence of eddy current loss due to heat generation concentration of the working coil pattern.

In addition, according to the present disclosure, the dummy via hole or the dummy pattern is formed in the central inner area in which the working coil pattern is not formed so as to be electrically insulated from the working coil pattern, such that a heat dissipation effect in a vertical direction is improved through the dummy via hole, and a heat dissipation effect in a front-rear direction or a left-right direction is improved through the dummy pattern, thereby effectively preventing thermal deformation of the coil circuit board module due to heat generation in the central inner area.

In addition, according to the present disclosure, the dummy via hole or the dummy pattern is formed in the central inner area in which the working coil pattern is not formed so as to be electrically insulated from the working coil pattern, such that a vertical rigidity is reinforced due to the dummy via hole and a front-rear rigidity or a left-right rigidity is reinforced due to the dummy pattern, thereby increasing the rigidity in the central inner area of the burner

In addition, according to the present disclosure, both the dummy via hole and the dummy pattern are disposed in the central inner area in which the working coil is not formed, so that the heat dissipation effect in each of the front-rear direction, the left-right direction, and the vertical direction may be improved, and the rigidity in each of the front-rear direction, the left-right direction, and the vertical direction may be reinforced. However, this should be interpreted as meaning that the heat dissipation improvement effect and the rigidity reinforcing effect on the central inner area are not limited to a specific direction, and may be relatively greater in the specific direction than in the other directions.

In addition, according to the present disclosure, the dummy via hole or the dummy pattern is formed in the central inner area in which the working coil pattern is not formed so as to be electrically insulated from the working coil pattern, thereby reducing a proportion of an insulating material to reduce a manufacturing cost.

In addition to the above-described effects, specific effects of the present disclosure will be described together while describing specific matters for implementing the present disclosure.

### [Description of Drawings]

FIG. 1 is a front perspective view of a cooking appliance according to an embodiment of the present disclosure.
FIG. 2 is a plan view of the cooking appliance shown in FIG. 1 and illustrates a state in which a display line is turned on.
FIG. 3 is a perspective view of the cooking appliance shown in FIG. 1.
FIG. 4 is an exploded perspective view of a cooktop of the cooking appliance shown in FIG. 1.
FIG. 5 is a plan view of the cooktop illustrated in FIG. 4, and is a see-thorough view of a structure under a top plate.
FIG. 6 is a schematic cross-sectional view for illustrating a multi-layer structure of a first coil circuit board module as shown in FIG. 4.
FIG. 7 is a plan view of a first layer constituting a multi-layer structure of the first coil circuit board module shown in FIG. 4, and FIG. 8 is a partially enlarged view of FIG. 7.
FIG. 9 is a plan view of a second layer constituting a multi-layer structure of the first coil circuit board module as shown in FIG. 4.
FIG. 10 is a partially enlarged view of FIG. 7 and illustrates patterns formed in each of first to twelfth layers.
FIG. 11 is a plan view of each of third to seventh layers constituting a multi-layer structure of the first coil circuit board module as shown in FIG. 4.
FIG. 12 is a plan view of each of eighth to twelfth layers constituting a multi-layer structure of the first coil circuit board module as shown in FIG. 4.
(a) in FIG. 13 is a plan view illustrating a portion of a first type pattern illustrated in FIG. 11, and (b) in FIG. 13 is a plan view illustrating a portion of a second type pattern illustrated in FIG. 12.
(a) in FIG. 14 is a partially enlarged view of (a) in FIG. 13, and (b) in FIG. 14 is a partially enlarged view of (b) in FIG. 13.
FIG. 15 is a schematic cross-sectional view illustrating a structure in which the first type patterns respectively constituting the third to seventh layers and the second type patterns respectively constituting the eighth to twelfth layers as illustrated in FIG. 4 are collectively connected to each other via a working coil via hole.
(a) in FIG. 16 is a partially enlarged view of (a) in FIG. 13, and (b) in FIG. 16 is a partially enlarged view of (b) in FIG. 13, which are partially enlarged views for illustrating a common terminal of a first type pattern and a common terminal of a second type pattern, respectively.
FIG. 17 is a partially enlarged view of FIG. 7 and illustrates a position where a dummy via hole according to the present disclosure is disposed.
FIGS. 18 and 19 are plan views illustrating a state in which a plurality of dummy via holes are formed in an inner central area of a working coil pattern constituting an individual burner, based on a first type pattern.
FIG. 20 is a partially enlarged view illustrating examples of a shape in which a plurality of dummy via holes are arranged in the inner central area illustrated in FIGS. 18 and 19 according to a first embodiment of the present disclosure.
FIG. 21 is a schematic cross-sectional view of a first coil circuit board module and schematically shows examples of a shape of a plurality of dummy via holes according to the first embodiment of the present disclosure.
FIG. 22 is a plan view illustrating a state in which a plurality of dummy patterns are formed in the inner central area shown in FIGS. 18 and 19 according to a second embodiment of the present disclosure, based on the first type pattern.
FIG. 23 is a partially enlarged view showing examples of a shape in which a plurality of dummy patterns are arranged in the inner central area shown in FIGS. 18 and 19 according to the second embodiment of the present disclosure.
FIG. 24 is a schematic cross-sectional view of a first coil circuit board module and schematically shows examples of a configuration in which a plurality of dummy patterns are disposed in a multi-layer structure according to the second embodiment of the present disclosure.
FIGS. 25 and 26 are plan and cross-sectional schematic views illustrating a configuration in which a plurality of dummy via holes and a plurality of dummy patterns are formed together in the internal central area illustrated in FIGS. 18 and 19 according to a third embodiment of the present disclosure.

### [Best Mode]

The above-mentioned purposes, features, and advantages will be described in detail later with reference to the attached drawings, so that those skilled in the art in the technical field to which the present disclosure belongs may easily implement the technical ideas of the present disclosure. In describing the present disclosure, upon determination that a detailed description of the publicly known technology related to the present disclosure may unnecessarily obscure the gist of the present disclosure, the detailed description will be omitted. Hereinafter, a preferred embodiment according to the present disclosure will be described in detail with reference to the attached drawings. In the drawings, identical reference numerals are used to indicate identical or similar components.

Although first, second, and the like are used to describe various components, these components are not limited by such terms. Such terms are only used to distinguish one component from another component, and unless specifically stated to the contrary, a first component may also be a second component.

Throughout the present document, unless otherwise stated, each component may be singular or plural.

Hereinafter, a first component being disposed "on top of (or under)" a second component may mean that the first component may be disposed in contact with a top surface (or a bottom surface) of the second component, as well as a third component may be interposed between the second component and the first component disposed "on top of (or under)" the second component.

Furthermore, when a first component is described as being "connected" or "coupled" to a second component, the components may be directly connected or coupled to each other, but a third component may be "interposed" between the components or the components may be "connected" or "coupled" to each other via the third components.

As used herein, the singular constitutes "a" and "an" are intended to include the plural constitutes as well, unless the context clearly indicates otherwise. In this application, terms such as "composed of" or "include" should not be construed as necessarily including all of various components or operations described herein, but should be construed that some components or operations among those may not be included or additional components or operations may be further included.

As used herein, the singular constitutes "a" and "an" are intended to include the plural constitutes as well, unless the context clearly indicates otherwise. In this application, terms such as "composed of" or "include" should not be construed as necessarily including all of various components or operations described herein, but should be construed that some components or operations among those may not be included or additional components or operations may be further included.

Throughout the present document, "A and/or B" means A, B, or A and B, unless otherwise specified, and "C to D" means equal to or greater than C and equal to or smaller than D unless otherwise specified.

### [Overall structure of cooking appliance]

In the present disclosure, embodiments in which a coil circuit board module is used in the cooking appliance 1 are described below.

However, in further embodiments, the coil circuit board module may be applied to other devices requiring induction heating.

For example, the coil circuit board module may be mounted on a washing machine to heat a water tank, a drum, or a washing tub inside the washing machine or to heat washing water. In another example, the coil circuit board module may be mounted on a water purifier and used to heat a hot water pipe or a water tank. In still another example, the coil circuit board module may be mounted on a clothes dryer or a clothes care apparatus to heat air for drying clothes, or the coil circuit board module may be mounted on an electric port or a rice cooker to heat liquid or food therein.

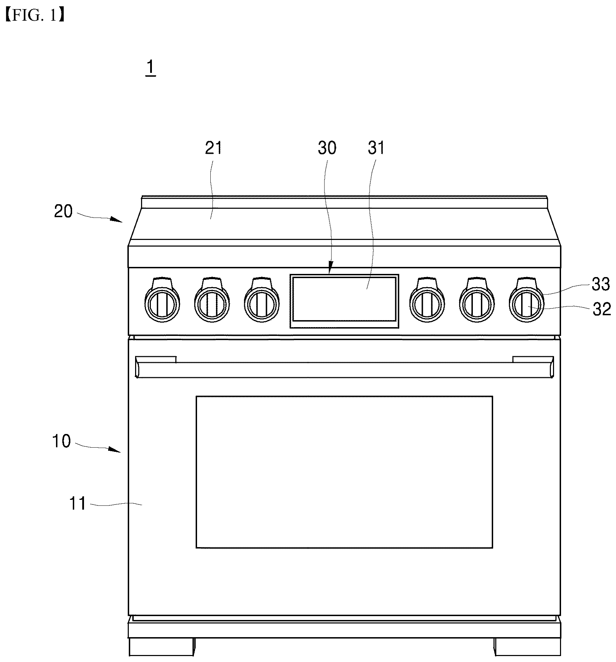

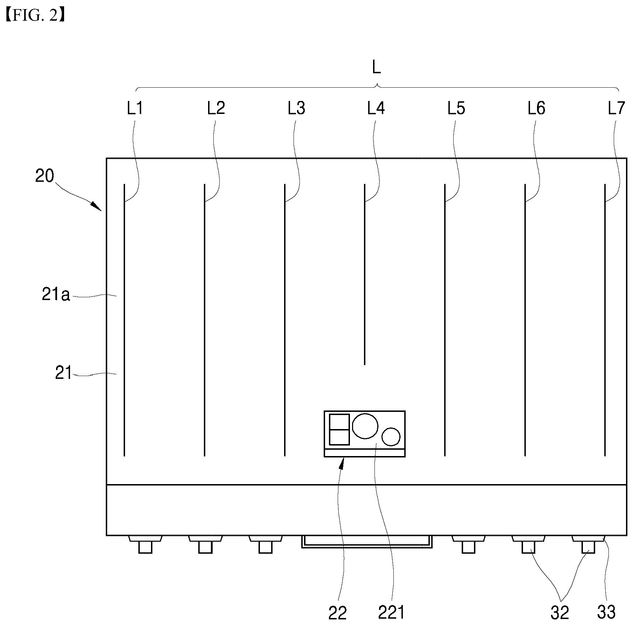

FIG. 1 is a perspective view illustrating the cooking appliance 1 according to an embodiment of the present disclosure, and FIG. 2 is a top view illustrating a cooktop 20 constituting the cooking appliance 1 illustrated in FIG. 1.

Referring to FIGS. 1 and 2, the cooking appliance 1 according to an embodiment of the present disclosure may include the cooktop 20 and an oven 10 disposed under the cooktop 20.

The cooking appliance 1 according to an embodiment of the present disclosure may be of an oven range type in which the cooktop 20 is disposed at an upper area and the oven 10 is disposed at a lower area. However, the present disclosure is not limited thereto, and the cooking appliance 1 according to an embodiment of the present disclosure may be embodied as the cooking appliance 1 including only the cooktop 20. Hereinafter, a case in which the cooking appliance 1 is embodied as being of the oven range type will be described by way of example.

The cooking appliance 1 according to an embodiment of the present disclosure is of the oven range type, thereby providing both a function of an oven as a closed cooking means, and a function of a cooktop as an open cooking means.

A cooking chamber may be formed inside the oven 10 serving as the closed cooking means. While the inside of the cooking chamber of the oven 10 is heated, food received therein may be cooked.

To this end, although not shown, the oven 10 may be provided with a heater for heating the inside of the cooking chamber. The heater may be a heating device using gas fuel or electricity.

A door 11 for selectively opening and closing the cooking chamber may be pivotably provided at the oven 10 of the cooking appliance 1.

For example, the door 11 may be provided in the oven 10 in a form of opening and closing the cooking chamber in a pull-down manner in which an upper end thereof rotates along a vertical direction around a lower end thereof.

A control panel 30 for operating the oven 10 and the cooktop 20 may be disposed on a top portion of a front surface of the cooking appliance 1.

Since the control panel 30 is disposed on the front surface of the cooking appliance 1, the control panel 30 may constitute a portion of an exterior of the front surface of the cooking appliance 1.

The control panel 30 may be provided with a plurality of switches for controlling the operation of the cooking appliance 1 and a display 31 for displaying an operation state of the cooking appliance 1.

In addition, as illustrated, the control panel 30 of the cooking appliance 1 may further include a plurality of knobs 32. That is, the plurality of knobs 32 for adjusting the operation of the cooking appliance 1 together with the display 31 may be included in the control panel 30 disposed on the top portion of the front surface of the cooking appliance 1.

Each knob 32 may be provided so as to be rotatable. The knob 32 may be provided to be able to control one of the oven 10 and the cooktop 20, or may be provided to be able to control both the oven 10 and the cooktop 20.

Via the manipulation of the knob provided as described above, one of a plurality of preset cooking modes may be selected, or a heating temperature or a heating step may be selected.

In addition, the control panel 30 of the cooking appliance 1 according to the present embodiment may further include a knob ring 33. The knob ring 33 may be disposed radially outwardly of the knob 32. For example, the knob ring 33 may be provided in a ring shape surrounding the knob 32 while being positioned in the radial direction outwardly thereof.

The knob ring 33 may serve to support the knob 32, and may serve to improve appearance quality of the cooking appliance 1 by finishing a surrounding appearance of the knob 32.

In addition, the knob ring 33 of the present embodiment may act as a timer setting switch and perform a role of displaying a timer time and an intensity of firepower together.

The knob ring 33 is installed to be rotatable independently of the knob 32, and a timer time may be set via a rotation of the knob ring 33 installed as described above.

As described above, the cooktop 20 may be disposed on top of the oven 10.

The cooktop 20 may perform a function of heating food or a container containing food which may be seated on an upper surface of the cooktop 20 or heating a heating target.

To this end, the cooktop 20 may include a top plate 21 which constitutes the upper surface of the cooktop 20 and on which the container containing food is seated or the heating target contacts.

In addition, a heater for heating the container containing food or heating the heating target may be provided inside the cooktop 20 and under the top plate 21.

The heater may be configured to include at least one burner. For example, the burner constituting the heater may be provided in a form including a working coil for converting an electrical force supplied thereto into a magnetic force or a heating coil for converting the electrical force supplied thereto into thermal energy.

The cooktop 20 of the cooking appliance 1 according to an embodiment of the present disclosure may operate in an induction heating manner.

To this end, the burner of the cooktop 20 may be configured to include the working coil. The burner including the working coil may operate under a high-frequency current generated and supplied thereto by an inverter to generate a strong magnetic field.

The magnetic field generated in the burner including the working coil may generate an eddy current in the container including a metal component. As the eddy current flows through the container, the heat may be generated to heat the container. As the container is heated, the food contained in the container may be heated.

However, the working coil applied to the conventional induction heating type cooktop is generally formed by twisting a plurality of electrically conductive wires to form a cable, and winding the cable in a spiral shape.

However, as will be described later, a working coil constituting the cooktop 20 of the cooking appliance 1 according to an embodiment of the present disclosure may be composed of a plurality of patterns stacked on a printed circuit board, each pattern being formed in a spiral shape.

As described above, the working coil of the cooking appliance 1 according to the present disclosure may have a structure in which the pattern is stacked on the printed circuit board and thus may be referred to as a working coil pattern.

A detailed configuration of the heater including the working coil pattern will be described later with reference to FIG. 2.

### [Overall configuration of cooktop]

Hereinafter, a configuration of the cooktop 20 constituting the cooking appliance 1 according to an embodiment of the present disclosure will be described with reference to FIGS. 2 to 4.

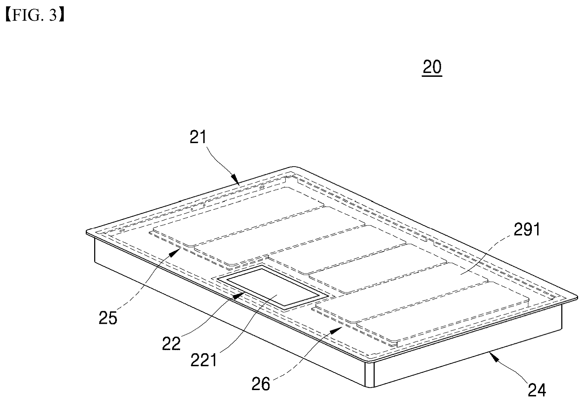

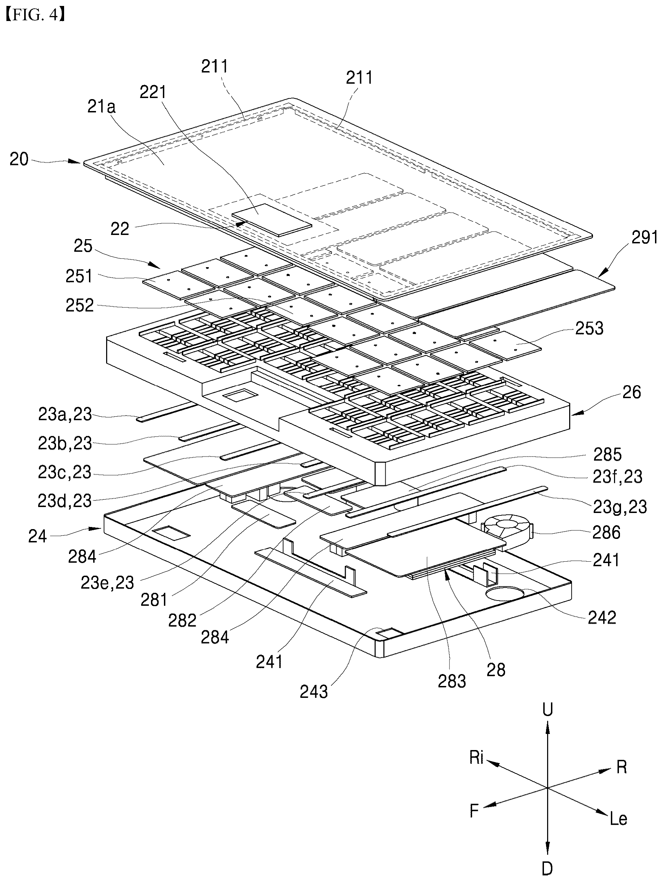

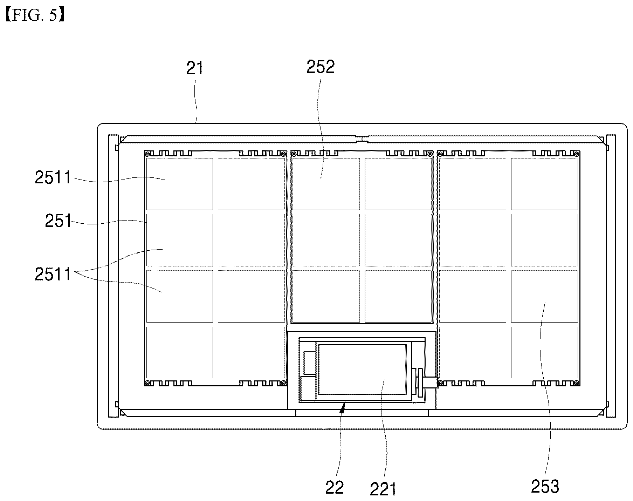

FIG. 2 is a top view of the cooktop 20 in a state in which a display line L is turned on. FIG. 3 is a perspective view of the cooktop 20 according to the present disclosure. FIG. 4 is an exploded perspective view of the cooktop 20 illustrated in FIG. 3. FIG. 5 is a plan view of the cooktop illustrated in FIG. 3, and is a see-thorough view of a structure under a top plate.

First, referring to FIGS. 2 to 5, in a similar manner to the oven 10 described above, the cooktop 20 according to the present embodiment may include a control panel 22.

As illustrated, the control panel 22 of the cooktop 20 may be disposed on the top plate 21, and may be disposed at a position closer to a front edge thereof for user convenience.

The control panel 22 may be provided with various switches for controlling the operation of the cooktop 20 and a display panel 221 for displaying the operation state of the cooktop 20.

As will be described later, when it is detected that the container is seated on an upper surface 21a of the top plate 21 using a sensing coil pattern 2514, an icon corresponding to the container may be displayed on the display panel 221 of the control panel 22 disposed on the cooktop 20. By way of example, the icon may be provided in a size and a shape corresponding to a size and a shape of the container, and may be disposed at a position of the display panel 221 corresponding to a position of the cooking appliance 1.

The user may press the displayed icon to select a container as indicated by the icon, and may perform a manipulation for controlling the operation of the cooking appliance 1 related to the selected container.

For example, the user may press the icon to select the container to be manipulated, and then select a desired heating temperature of the selected container.

When the heating of the container is started via the manipulation of the control panel 22 as described above, the start of the heating of the container may be displayed on the top plate 21 using the display line L as shown in FIG. 2.

As illustrated in FIG. 2, a plurality of display lines L may be disposed on the top plate 21 of the cooktop 20.

The display line L displays information related to a position of the container, a heated state of the container, a temperature, etc. on the top plate 21 in a form of a light emission area, and thus may visually transmit the information to the user.

FIG. 2 shows an embodiment in which a total of seven display lines L are provided. These display lines L may be referred to as first to seventh display lines L1, L2, L3, L4, L5, L6, and L7 in an order starting from a left side of the top plate 21 in terms of convenience. The present disclosure is not limited thereto. However, for convenience, an example in which a total of seven display lines L are provided will be described

As illustrated, each of the display lines L may be a light emitting area in which a width in a left-right direction is much smaller than a length in a front-rear direction.

The display line L may be implemented using a light source module 23 disposed under the top plate 21 and disposed on a board supporter 26 to be described later so that each display line L may be formed in a form of the light emission area.

The light source module 23 may include a plurality of light source elements 231 for generating visible light, and a light source circuit board 232 on which the plurality of light source elements 231 are mounted.

The plurality of light source elements 231 may be disposed to irradiate visible light toward a lower surface of the top plate 21, and the incident visible light may travel through a light-transmission hole extending through the board supporter 26, a light-transmission slit hole H_sl formed in each of coil circuit board modules constituting a heater 25, and a clearance formed between adjacent coil circuit board modules, as will be described later and then be irradiated to a lower surface of the top plate 21.

The light source module 23 may be configured to include the plurality of light source elements 231 receiving power to generate visible light, and the light source circuit board 232 on which the plurality of light source elements 231 are mounted.

The light source element 231 may be applied without limitation as long as it is a means capable of receiving power and generating predetermined visible light, and may be, for example, an LED element. However, hereinafter, the present disclosure will be described based on an embodiment in which an LED element is applied as the light source element 231. The present disclosure is not limited thereto.

As illustrated, each light source circuit board 232 may linearly extend in the front-rear direction in a corresponding manner to each display line L extending linearly, and the plurality of light source elements 231 may be disposed on each light source circuit board 232 and be linearly arranged so as to be spaced apart from each other by an equal spacing or non-uniform spacings in the front-rear direction.

In addition, as described above, each of the plurality of light source modules 23 may be provided to independently irradiate visible light to each of the first to seventh display lines L1, L2, L3, L4, L5, L6, and L7. The plurality of light source modules 23 may be referred to as first to seventh light source modules 23a, 23b, 23c, 23d, 23e, 23f, and 23g in an order starting from the left side of the top plate 21.

The first to seventh light source modules 23a, 23b, 23c, 23d, 23e, 23f, and 23g may be arranged so as to be spaced apart from each other in the left-right direction in a corresponding manner to the first to seventh display lines L1, L2, L3, L4, L5, L6, and L7.

As will be described later, the spacing between the adjacent display lines L and the spacing between the adjacent light source modules 23 may be equal to or slightly greater than a width in the left-right direction of the working coil pattern 2512 constituting the heater 25.

As illustrated, the cooktop 20 of the cooking appliance 1 according to an embodiment of the present disclosure may include a bottom casing 24 constituting a front surface, a rear surface, a front surface, both opposing side surfaces, and a lower surface of the exterior of the cooktop 20.

The bottom casing 24 may be formed in a form in which an upper surface thereof is entirely opened, and the top plate 21 described above may be coupled to the opened upper surface thereof.

As shown in FIG. 4, a fastening bracket 211 for coupling to the bottom casing 24 to the top plate may be disposed on the lower surface of the top plate 21 at a position corresponding to a position of an upper end of the bottom casing 24.

As the top plate 21 is coupled to the upper end of the bottom casing 24, an inner space may be defined so as to be surrounded with the top plate 21 and the bottom casing 24 and may accommodate therein a plurality of internal components constituting the cooktop 20.

In addition, a plurality of mount brackets 241 may be provided integrally with or separately from the bottom casing 24.

The mount bracket 241 may be disposed in the inner space of the cooktop 20, and may protrude upwardly from the lower surface of the mount bracket 241 toward the electronic/electrical components.

The mount bracket 241 may support several electronic/electrical components 28 constituting the cooktop 20 while being disposed thereunder, thereby preventing the occurrence of sagging of components such as a main circuit board module 281, a SMPS circuit board module 282, an inverter circuit board module 283, a resonance circuit board module 284, an EMI filter module 285, etc., and supporting these components.

In addition, as illustrated in FIG. 4, an air intake hole 242 and an air exhaust hole 243 through which air for cooling the various electronic/electrical components constituting the cooktop 20 flows may be formed to extend through a lower surface 24a of the bottom casing 24 in the vertical direction.

The cooktop 20 of the cooking appliance 1 according to an embodiment of the present disclosure may further include the heater 25 including a working coil for heating a container in an induction heating manner, and as described above, the working coil may include a plurality of working coil patterns 2512 stacked on the printed circuit board, each pattern being formed in a spiral manner.

In consideration of the fact that the plurality of working coil patterns 2512 are stacked in a plurality of multi-layer structures to form a burner, the printed circuit board formed by stacking the working coil patterns 2512 may be referred to as a coil circuit board module.

In addition, as will be described later, the plurality of working coil patterns 2512, the plurality of sensing coil patterns 2514, the plurality of lead patterns 2513, etc. constituting the coil circuit board module may be formed in a manner similar to a general scheme of manufacturing a pattern of a printed circuit board. Therefore, in consideration of this fact, components referred to as the patterns below may be referred to as various terms such as a conductive portion, a metal portion, a copper portion, a thin film portion, and a printed portion. In addition, in a similar manner to the plurality of working coil patterns 2512, the plurality of sensing coil patterns 2514, and the plurality of lead patterns 2513, a dummy pattern provided in the coil circuit board module may be referred to as a dummy conductive portion, a dummy metal portion, a dummy copper portion, a dummy thin film portion, a dummy printed portion, or the like.

In addition, in a similar manner to a general printed circuit board having a multilayer structure, the coil circuit board module of the present disclosure may include a working coil via hole H_v1, a sensing coil via hole H_v2, and a temperature sensor via hole H_v3 for electrically connecting the patterns disposed in different layers to each other, and a plurality of dummy via holes not electrically connected to other patterns. Similarly to the related art, the via holes may be formed in the through-holes formed in the coil circuit board module in a physical, chemical deposition, or coating manner, and thus, may be referred to as various terms such as a conductive coated portion or a conductive deposited portion.

A plurality of coil circuit board modules constituting the heater 25 may be provided in consideration of manufacturing convenience and efficiency.

FIGS. 4 and 5 illustrate an embodiment of the cooktop 20 including the heater 25 including a total of three coil circuit board modules. However, the present disclosure will be described below on the basis of an embodiment in which the three coil circuit board modules are provided as illustrated in the drawing. The present disclosure is not limited thereto.

The three coil circuit board modules 251, 252, and 253 are referred to as a first coil circuit board module 251, a second coil circuit board module 252, and a third coil circuit board module 253 in an order starting from the left side.

Each of the coil circuit board modules 251, 252, and 253 may include a plurality of burners 2511 for heating the container.

FIG. 5 illustrates an embodiment in which eight burners 2511 may be provided in each of the first coil circuit board module 251 and the third coil circuit board module 253, and six burners 2511 may be provided in the second coil circuit board module 252. As will be described later, the number of burners 2511 may be set to vary depending on the size and output of the cooktop 20. Hereinafter, the present disclosure will be described based on an example in which each of the first coil circuit board modules 251 and the third coil circuit board modules 253 has eight burners 2511, and the second coil circuit board module 252 has six burners.

In addition, although FIG. 5 illustrates that the shapes and sizes of the respective burners 2511 are the same as each other, this is merely an example. Similarly, the shape and size of the burners 2511 may be set to vary according to the size and output of the cooktop 20.

In each of the coil circuit board modules 251, 252, and 253, the working coil patterns 2512 constituting each of the plurality of burners 2511 may be stacked in multiple layers.

In addition, in each of the coil circuit board modules 251, 252, and 253, sensing coil patterns 2514 as a means for detecting whether the container is seated at a specific position may be stacked on the upper surface 21a of the top plate 21.

In addition, a temperature sensor 2515 for sensing a temperature of each of corresponding areas of the top plate 21 may be provided in each of the coil circuit board modules 251, 252, and 253.

In this regard, as will be described later, the working coil pattern 2512, the sensing coil pattern 2514, and the temperature sensor 2515 may be provided in a form integrated with each other in each of the coil circuit board modules 251, 252, and 253. Therefore, a vertical length of the heater 25 of the cooktop 20 according to the present disclosure is significantly reduced compared to the related art, so that the vertical size of the cooktop 20 may be reduced, thereby significantly improving space utilization and significantly simplifying a manufacturing process of the cooktop 20.

Each of the working coil pattern 2512 and the sensing coil pattern 2514 may extend in a spiral shape. The working coil patterns 2512 may be stacked in a vertical direction. The sensing coil patterns 2514 may be stacked in a vertical direction.

In this regard, as will be described below, each of the first to third coil circuit board modules 251, 252, and 253 may be formed in a form in which the working coil patterns 2512 are stacked in 10 to 12 layers and the sensing coil patterns 2514 are stacked in two layers in the vertical direction. Accordingly, each of the coil circuit board modules 251, 252, and 253 may have a multi-layer structure having 12 to 14 layers.

In addition, since a thickness in the vertical direction of each layer is small due to the characteristics of a layer stacking process of the printed circuit board, the number of layers of each of the coil circuit board modules 251, 252, and 253 may exceed 14. That is, although the number of layers of each of the coil circuit board modules 251, 252, and 253 is determined according to a specific design condition, there is no particular limitation to the number of layers of each of the coil circuit board modules 251, 252, and 253.

In a cross-sectional view perpendicular to a current traveling direction, the working coil pattern 2512 having a spiral shape should be formed while the copper pattern extends along the vertical and horizontal directions. Therefore, the working coil pattern 2512 having 4 or greater layers may be applied. That is, each of the coil circuit board modules 251, 252, and 253 may have at least four layers of the copper pattern

Each sensing coil pattern may be disposed inwardly of an area occupied with the working coil pattern 2512 constituting the individual burner 2511, or may be disposed in an area between a pair of adjacent working coil patterns 2512.

In the present embodiment, a pair of sensing coil patterns 2514 may be disposed inwardly of an area occupied with each working coil pattern 2512, and a pair of sensing coil patterns 2514 may be disposed in an area between the pair of adjacent working coil patterns 2512, as will be described later in consideration of the efficiency and accuracy of container detection.

Each temperature sensor 2515 for sensing the temperature of the top plate 21 may be disposed at a position corresponding to a center of each of the sensing coil patterns 2514.

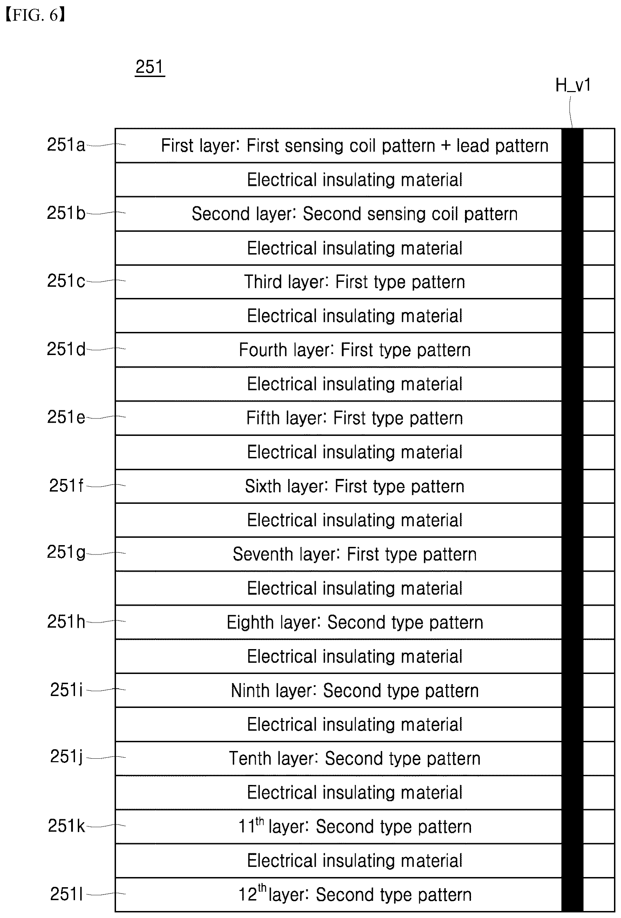

Details of the working coil pattern 2512, the sensing coil pattern 2514, and the temperature sensor 2515 constituting the first to third coil circuit board modules 251, 252, and 253 will be described later with reference to FIG. 6.

The cooktop 20 of the cooking appliance 1 according to an embodiment of the present disclosure may further include the board supporter 26.

The internal components disposed inside the cooktop 20 may be mounted on the board supporter 26 which serves to support the internal components.

More specifically, as illustrated in FIGS. 4, the first to third coil circuit board modules 251, 252, and 253 and a ferrite core module 27 may be seated on an upper surface of the board supporter 26. Therefore, the board supporter 26 functions as a coil base on which a working coil and a ferrite core are mounted conventionally.

In addition, as shown in FIG. 4, several electronic/electrical components 28 constituting the cooktop 20 may be installed under the board supporter 26.

The electronic/electrical components 28 may include the main circuit board module 281, the SMPS circuit board module (a switching mode power supply device) 282, the inverter circuit board module 283, the resonance circuit board module 284, the EMI filter module 285, a blower module 286, a light source module 23, etc.

These electronic/electrical components 28 may be disposed in a space formed under the board supporter 26 and between the lower surface 24a of the bottom casing 24 and the board supporter 26.

By way of example, in order to effectively accommodate these electronic/electrical components 28, the board supporter 26 may have a box shape turned upside down such that a lower surface thereof facing the bottom casing 24 is entirely open.

Accordingly, the main circuit board 281, the SMPS circuit board (switching mode power supply device) 282, the inverter circuit board 283, the resonance circuit board 284, the EMI filter 285, a blowing fan module 286, and the light source module 23 may be assembled with the board supporter 26 in a stacked manner in an accommodation space formed inside the board supporter 26.

As described above, the first to third coil circuit board modules 251, 252, and 253 are seated on the upper surface of the board supporter 26, and the electronic/electrical component 28 is seated on the lower surface of the board supporter 26 and inside the board supporter 26. Thus, a wiring structure between the electronic/electrical component 28 and a wiring structure between the electronic/electrical component 28 and the first to third coil circuit board modules 251, 252, and 253 may be significantly simplified and simple.

In particular, in a conventional cooktop 20, almost all components need to be disassembled in a reverse order of an assembly process in order to repair the inverter circuit board as a major cause of failure and defect.

On the contrary, in the cooktop 20 of the cooking appliance 1 according to an embodiment of the present disclosure, when only the bottom casing 24 is disassembled in a state in which the cooktop is turned upside down such that the bottom casing 24 faces upwardly, a user may have easy access to the electronic/electrical component 28 such as the inverter circuit board module 283, thereby easily repairing or replacing the electronic/electrical component 28 in which a failure has occurred.

In this regard, the assembly process of the cooktop 20 of the cooking appliance 1 according to an embodiment of the present disclosure will be briefly described.

First, a plurality of ferrite core modules 27 may be assembled to the upper surface 261 of the board supporter 26.

The ferrite core module 27 according to an embodiment of the present disclosure may be configured in a modularized manner by coupling a plurality of ferrite cores to each other. This is devised with taking into account that crack defects or magnetic field loss may occur when a ferrite core formed as a single body and having a relatively large volume is applied.

As described above, the plurality of ferrite cores are modularized to form the ferrite core module 27 which in turn may be installed on the board supporter 26, thereby reducing the number of components and simplifying the assembly process.

By way of example, the ferrite core module 27 may be manufactured in an insert injection manner. As described above, the ferrite core module 27 is manufactured in the insert injection manner, such that a separate jig for fixing the ferrite core unit employed when the cooktop 20 is assembled as in the related art may be omitted.

In addition, as described above, the ferrite cores are modularized to form the plurality of ferrite core modules 27. Thus, even when some of the ferrite cores are damaged, the damaged cores may be repaired via simple replacement of the damaged ones.

When the installation of the plurality of ferrite core modules 27 on the upper surface 261 of the board supporter 26 has been completed, the first to third coil circuit board modules 251, 252, and 253 may be seated on top of the ferrite core modules 27.

Next, in a state in which the first to third coil circuit board modules 251, 252, and 253 have been seated thereon, the board supporter 26 may be turned upside down, and the electronic/electrical components 28 may be assembled.

As described above, several electronic/electrical components 28 may be installed and assembled on the lower surface of the board supporter 26. In this regard, these electronic/electrical components 28 may be installed and assembled on the board supporter 26 while being in a turned upside down state.

The cooktop 20 of the cooking appliance 1 according to an embodiment of the present disclosure may further include an thermal insulator 291 disposed between the first to third coil circuit board modules 251, 252, and 253 and the top plate 21 and on top of the first to third coil circuit board modules 251, 252, and 253.

The thermal insulator 291 is disposed on the upper surface 21a of the top plate 21 and serves to minimize the transfer of heat generated from the container heated by the working coil pattern 2512 to the working coil pattern 2512.

In order to perform such a heat insulation function, the thermal insulator 291 may be disposed in a form of a pad covering an entirety of the first to third coil circuit board modules 251, 252, and 253.

In the present embodiment, the thermal insulator 291 may be divided into a plurality of pads.

More specifically, each of the thermal insulators 291 may be divided into a plurality of pads, each having a width in the left-right direction corresponding to a width in the left-right direction of the burner 2511 formed in each of the first to third coil circuit board modules 251, 252, and 253.

As described above, the thermal insulator 291 is divided into a plurality of thermal insulators 291, such that a predetermined gap may be formed between the adjacent thermal insulators 291. Thus, the visible light generated from the light source module 23 may travel through the predetermined gap and be irradiated to the lower surface of the top plate 21 so that the above-described display line L may be displayed on the top plate 21.

The thermal insulator 291 may additionally serve to electrically insulate the working coil pattern 2512 or the sensing coil pattern 2514 formed in the first to third coil circuit board modules 251, 252, and 253 from the top plate 21.

In this regard, the thermal insulator 291 may be made of a material having both thermal insulation performance and electrical insulation performance.

In one example, although not shown, in order to additionally supplement the electrical insulation performance of the thermal insulator 291, an electrical insulator may be added between the thermal insulator 291 and the top plate 21 and be disposed on top of the thermal insulator 291. By way of example, the electrical insulator may be a mica sheet having a thickness smaller than a vertical thickness of the thermal insulator 291.

### [Detailed configuration of coil circuit board module]

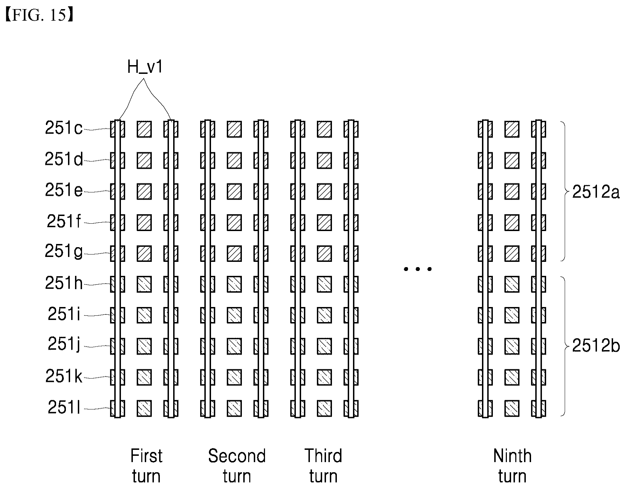

Hereinafter, a detailed configuration of each of the coil circuit board modules 251, 252, and 253 of the cooktop 20 constituting the cooking appliance 1 according to an embodiment of the present disclosure will be described with reference to FIGS. 6 to 15.

As described above, the cooktop of an embodiment of the present disclosure may include the first to third coil circuit board modules 251, 252, and 253.

In this regard, the first to third coil circuit board modules 251, 252, and 253 may be configured in substantially the same manner as each other except for the number of working coil patterns 2512 and the number of sensing coil patterns 2514 constituting the burner 2511.

Therefore, hereinafter, the description will be made based on the first coil circuit board module 251. Unless otherwise described, the description as set forth below may be applied to the second coil circuit board module 252 and the third coil circuit board module 253 in substantially the same manner.

First, as described above, the first coil circuit board module 251 may be formed by stacking the working coil patterns 2512 in multiple layers so as to constitute each of the plurality of burners 2511.

As illustrated in FIG. 6, for example, the first coil circuit board module 251 may include working coil patterns 2512 vertically arranged in a multi-layer structure of 10 layers, sensing coil patterns 2514 vertically arranged in a multi-layer structure of 2 layers, and each electrical insulating material disposed between adjacent ones of the working coil patterns 2512 and the sensing coil patterns 2514 to electrically insulate the adjacent ones from each other. The electrical insulating material may be formed by curing a prepreg composed of a thermosetting resin generally used to form a printed circuit board and glass fibers. In an example, the applicable thermosetting resin is preferably epoxy resin-based, and specifically, FR-4 may be applied as the applicable thermosetting resin.

The electrical insulating material including the prepreg as described above may be disposed between the layers of the working coil pattern 2512 having the multi-layer structure to insulate the coil patterns of the layers from each other, and may be disposed between the sensing coil patterns 2514 to insulate the sensing coil patterns 2514 from each other. In addition, the electrical insulating material may fill an area in which the patterns such as the working coil pattern 2512, the sensing coil pattern 2514, and the lead coil pattern 2513 are absent and thus may serve to constitute a layered structure of the individual layer.

Therefore, based on the working coil pattern 2512 and the sensing coil pattern 2514, the first coil circuit board module 251 may have a multi-layer structure having a total of 12 layers from a first layer 251a constituting the uppermost layer to the twelfth layer 2511 constituting the lowermost layer along the vertical direction.

In addition, a coating layer (not shown) may be deposited on the uppermost layer and the lowermost layer of the first coil circuit board module 251. The coating layer serves as an electrical insulation layer and may also serve to prevent the inside of the cooktop 20 from being easily visible through the top plate 21 made of a transparent material. To this end, the coating layer may be coated so as to have a black color.

In one example, a dummy via hole H_vd to be described later may be formed after the coating layer is formed. That is, a conductive material constituting the dummy via hole H_vd may be exposed to the outside, and may be visible through the top plate 21. In addition, a dummy pattern 2519 to be described later may be screened with the coating layer or formed in the middle layer between the uppermost layer and the lowermost layer and thus may not be exposed to the outside through the top plate 21.

However, the present disclosure is not limited thereto. After the dummy via hole H_vd or the dummy pattern 2519 is formed, a process of forming the coating layer may be performed. Accordingly, the dummy via hole H_vd or the dummy pattern 2519 may not be exposed to the outside.

In addition, among the components of the first coil circuit board module 251, a high-power terminal pattern 2516 that requires electrical contact and thus needs to be exposed to the outside may not be coated with the coating layer.

In this regard, the first sensing coil pattern 2514a constituting the sensing coil pattern 2514 may be disposed at the first layer 251a of the first coil circuit board module 251 having the 12-layers structure.

In addition, a lead pattern 2513 may be disposed at the first layer 251a to electrically connect the first sensing coil pattern 2514a to a signal processor 2518 to be described later or to electrically connect the working coil pattern 2512 disposed at each of the third to twelfth layers 251c, 251d, 251e, 251f, 251g, 251h, 251i, 251j, 251k, and 2511 to the high-power terminal pattern 2516 to which the high-frequency power is applied.

In this regard, the lead pattern 2513 may include a first lead pattern 2513a for electrically connecting the working coil pattern 2512 disposed at each of the third to twelfth layers 251c, 251d, 251e, 251f, 251g, 251h, 251i, 251j, 251k, and 2511 to the high-power terminal pattern 2516, and a second lead pattern 2513b for electrically connecting the first sensing coil pattern 2514a to the signal processor 2518.

In addition, although not shown in FIG. 6, the temperature sensor 2515 for sensing the temperature of the top plate 21, the high-power terminal pattern 2516 to which high-frequency power is supplied from the inverter circuit board module 283, the signal processor 2518 for processing an output signal of the sensing coil pattern 2514 and an output signal of the temperature sensor 2515, and a third lead pattern 2513c for electrically connecting the temperature sensor 2515 and the signal processor 2518 to each other may be further added to the first layer 251a.

A second sensing coil pattern 2514b constituting the sensing coil pattern 2514 and a second lead pattern 2513b electrically connecting the second sensing coil pattern 2514b to the signal processor 2518 may be disposed at the second layer 251b of the first coil circuit board module 251.

That is, in order to increase the efficiency and effect of sensing of the container, the sensing coil pattern 2514 may include the first sensing coil pattern 2514a disposed at the first layer 251a and the second sensing coil pattern 2514b disposed at the second layer 251b.

In this regard, as will be described later, the first sensing coil pattern 2514a and the second sensing coil pattern 2514b may be configured to be connected in series with each other via a sensing coil via hole H_v2 extending through the first layer 251a and the second layer 251b, thereby serving as the single sensing coil pattern 2514.

The second sensing coil pattern 2514b constituting the sensing coil pattern 2514 may be disposed on the second layer 251b of the first coil circuit board module 251.

As will be described later, the working coil pattern 2512 disposed in the cooktop 20 of the cooking appliance 1 according to an embodiment of the present disclosure may include a first type pattern 2512a and a second type pattern 2512b in which a traveling direction or a winding direction of individual pattern strands 2512a-1 and 2512b-1 are opposite to each other so that the magnetic field may evenly act on the container.

As illustrated in FIG. 6, for example, the working coil pattern 2512 of the first type pattern 2512a may be formed at each of the third to seventh layers 251c, 251d, 251e, 251f, and 251g. In this regard, in the first type pattern 2512a, the traveling direction or the winding direction of the individual pattern strand 2512a-1 is a first direction.

In addition, in an example, the working coil pattern 2512 of the second type pattern 2512b may be formed at each of the eighth to twelfth layers 251h, 251i, 251j, 251k, and 2511. In this regard, in the second type pattern 2512b, the traveling direction or the winding direction of the individual pattern strand 2512b-1 is a second direction.

In this regard, as illustrated, the first lead pattern 2513a formed in the first layer 251a, the first type pattern 2512a disposed in each of the third to seventh layers 251c, 251d, 251e, 251f, and 251g, and the second type pattern 2512b disposed in each of the eighth to twelfth layers 251h, 251i, 251j, 251k, and 2511 may be configured to be collectively connected to each other via a working coil via hole H_v1 continuously extending through the first layer 251a to the twelfth layer 2511.

Accordingly, the plurality of first type patterns 2512a and the plurality of second type patterns 2512b constituting a specific burner among the plurality of burners as described below may be collectively connected in series to each other via the working coil via hole H_v1.

In one example, although not shown, an electrical insulating material may be additionally formed on top of the first layer 251a and under the twelfth layer 2511.

The multi-layer structure of the first coil circuit board module 251 illustrated in FIG. 6 is merely an example.

That is, the multi-layer structure may be modified so that the second sensing coil pattern 2514b is disposed at the sixth layer 251f or the seventh layer 251g serving as a middle layer or disposed at the twelfth layer 2511 serving as the lowermost layer as a layer other than the second layer 251b.

In addition, although FIG. 6 illustrates that the first type patterns 2512a are consecutively arranged from the third layer 251c to the seventh layer 251g and the second type patterns 2512b are consecutively arranged from the eighth layer 251h to the twelfth layer 251l, the present disclosure is not limited thereto, and the first type patterns 2512a and the second type patterns 2512b may be alternately and repeatedly arranged with each other vertically.

It will be considered that such a modified example naturally falls within the scope of the present disclosure. However, hereinafter, the description will be given based on the multi-layer structure of the first coil circuit board module 251 as shown in FIG. 6. However, the present disclosure is not limited thereto.

In the first coil circuit board module 251 having the multi-multi-layer structure, a shape of the working coil pattern 2512 serving as the second type pattern 2512b may be printed on a copper thin film in a masking manner, an unnecessary portion may be removed using an etching process to form a pattern, and an electrical insulating material may be coated on the formed pattern to form the twelfth layer 2511 serving as the lowest layer.

A thickness of the copper thin film applied in this embodiment may be in a range of 0.13mm to 0.15mm, preferably 0.14mm.

Therefore, when additional surface treatment or the like is not performed during the layer formation process, the thickness in the vertical direction of the individual pattern formed via the patterning of the copper thin film may be in a range of 0.13mm to 0.15mm.

In addition, a thickness of the electrical insulating material applied in the present embodiment may be in a range of 0.09mm to 0.11, preferably 0.1mm.

As described above, the twelfth layer 2511 serving as the lowermost layer has been formed, and then, the same process as the process of forming the twelfth layer 2511 is repeated thereon, thereby constituting the multi-layer structure as shown in FIG. 6.

Therefore, when the formation of the first coil circuit board module 251 having a total of 12 layers has been completed, a thickness of the first coil circuit board module 251 in the vertical direction may be in a range of 2.7mm to 3.3mm, preferably 3 mm.

A means known in the art may be applied to a method for manufacturing the multilayer printed circuit board for forming the first coil circuit board module 251 having the above-described shape and structure, and thus a detailed description of the manufacturing method will be omitted below.

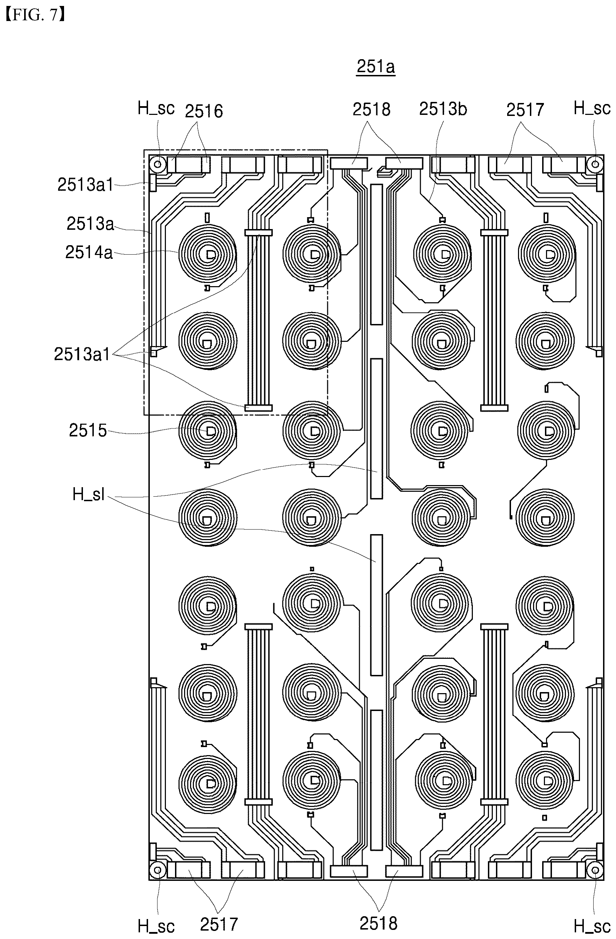

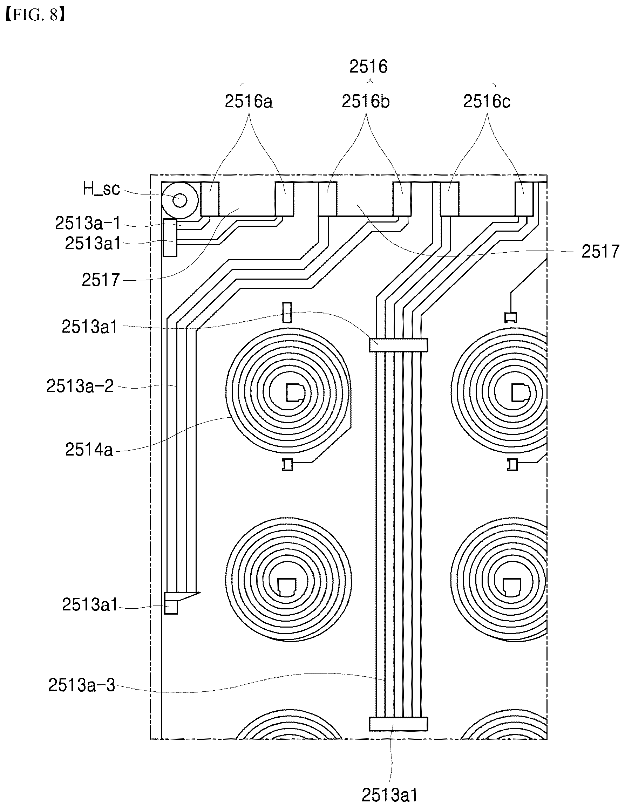

FIG. 7 and FIG. 8 illustrate a plan view of the first layer 251a and the second layer 251b of the first coil circuit board module 251 having the multilayer structure, respectively.

In the present embodiment, the first coil circuit board module 251 may be constructed to have a rectangular shape in which a width in the front-rear direction is greater than a width in the left-right direction, based on the state in which the first coil circuit board module 251 is disposed in the cooktop 20.

Correspondingly, each of the first layer 251a serving as the uppermost layer and the second layer 251b serving as the next uppermost layer may be constructed to have a rectangular shape in which a width in the front-rear direction is greater than a width in the left-right direction.

As described above, the first sensing coil pattern 2514a constituting one layer of the sensing coil pattern 2514 arranged in two layers may be disposed in the first layer 251a. The second sensing coil pattern 2514b constituting the other layer of the sensing coil pattern 2514 arranged in the two layers may be disposed in the second layer 251b.

In this regard, as illustrated, each of the first sensing coil pattern 2514a and the second sensing coil pattern 2514b may be wound in a shape different from a shape in which the working coil pattern 2512 is wound.

That is, each of the first sensing coil pattern 2514a and the second sensing coil pattern 2514b may be wound in a circular spiral shape. By way of example, each of the first sensing coil pattern 2514a and the second sensing coil pattern 2514b may be set to have a winding number of 18 turns, and an outer diameter thereof may be in a range of 32mm to 34mm, preferably, 33mm. In addition, a width of each of the individual pattern strands constituting each of the first sensing coil pattern 2514a and the second sensing coil pattern 2514b may be in a range of 0.27mm to 0.33mm, preferably 0.3mm.

As will be described later, the working coil pattern 2512 is wound in a quadrilateral spiral shape.

In addition, each of the first sensing coil pattern 2514a and the second sensing coil pattern 2514b is positioned so as to partially overlap the working coil pattern 2512 in the vertical direction.

Accordingly, there is a possibility that a malfunction or a sensing error of each of the first sensing coil pattern 2514a and the second sensing coil pattern 2514b may occur due to the overlapping area.

As described above, each of the first sensing coil pattern 2514a and the second sensing coil pattern 2514b is wound in the circular spiral shape, such that interference between each of the first sensing coil pattern 2514a and the second sensing coil pattern 2514b and the working coil pattern 2512 wound in the quadrilateral spiral shape may be minimized. Thus, the possibility of malfunction and detection error of each of the first sensing coil pattern 2514a and the second sensing coil pattern 2514b may be minimized.

Each of the first sensing coil pattern 2514a and the second sensing coil pattern 2514b may be wound so that a winding start point thereof is not positioned at a center of the circular spiral. That is, a first central inner area in which each of the first sensing coil pattern 2514a and the second sensing coil pattern 2514b is not formed may be formed in a center area of the circular spiral shape.

The temperature sensor 2515 may be mounted in the central inner area of each of the first sensing coil pattern 2514a as described below. In order to distinguish the central inner area of the first sensing coil pattern 2514a from a central inner area formed inwardly of the working coil pattern 2512 described later, the central inner area of the first sensing coil pattern 2514a is referred to as the first central inner area below.

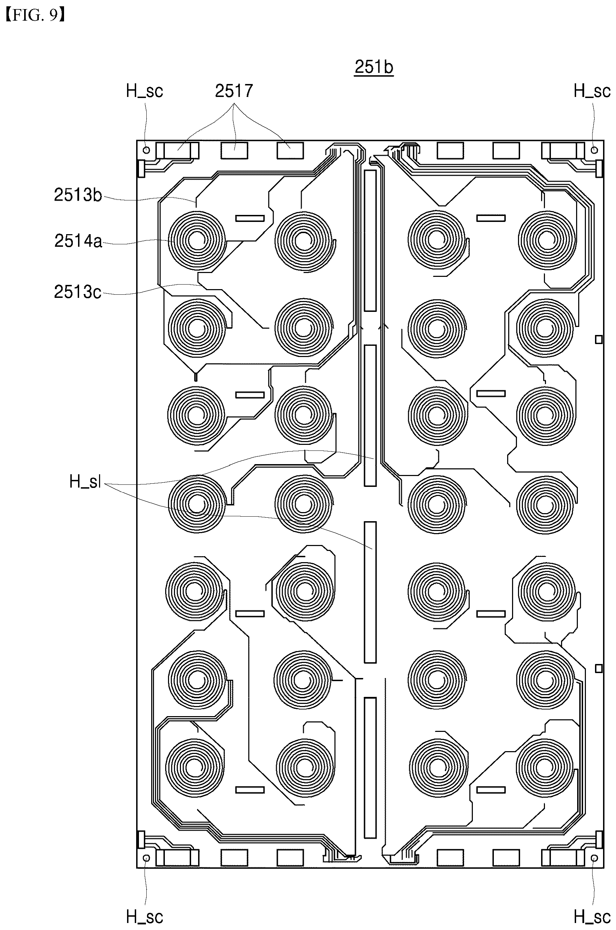

A detailed configuration of the arrangement of the temperature sensor 2515 will be described later with reference to FIG. 9.

In the present embodiment, a plurality of first sensing coil patterns 2514a and a plurality of second sensing coil patterns 2514b may be provided.

More specifically, each of some of the plurality of first sensing coil patterns 2514a may be entirely disposed in an area of a specific burner, while each of the others thereof may be disposed across a pair of adjacent burners 2511. Each of some of the plurality of second sensing coil patterns 2514b may be entirely disposed in an area of the specific burner, while each of the others thereof may be disposed across the pair of adjacent burners 2511.

By way of example, in the embodiment as illustrated in FIG. 7, when the first coil circuit board module 251 includes a total of eight burners 2511, a total of 28 first sensing coil patterns 2514a and a total of 28 second sensing coil patterns 2514b may be provided.

However, this is merely an example, and the number of the first sensing coil patterns 2514a may be adjusted to vary according to the size of the individual burner 2511 and the size of the first coil circuit board module 251. However, hereinafter, the description will be made based on an embodiment in which 28 first sensing coil patterns 2514a and 28 second sensing coil patterns 2514b are provided in the first coil circuit board module 251. The present disclosure is not limited thereto.

The first sensing coil patterns 2514a disposed at different positions may be constructed to have substantially the same number of turns, and similarly, the second sensing coil patterns 2514b disposed at different positions may be constructed to have the same number of turns.

A sensing coil via hole H_v2 may be formed at a start point or an end point of the first sensing coil pattern 2514a, and the sensing coil via hole H_v2 may be connected to an end point or a starting point of the second sensing coil pattern 2514b. Accordingly, the first sensing coil pattern 2514a and the second sensing coil pattern 2514b may be connected in series to each other to form the single sensing coil pattern 2514.

A start point or an end point not connected to the sensing coil via hole H_v2 may be electrically connected to the signal processor 2518 provided in the first layer 251a via the second lead pattern 2513b formed in the first layer 251b or the second layer 25l a, as shown in FIGS. 7 and 8.

In one example, the temperature sensor 2515 to be described later may be electrically connected to the signal processor 2518 via the third lead pattern 2513c. As illustrated in FIG. 8, the third lead pattern 2513c may be formed in the second layer 251b.

As illustrated in FIG. 7, when a total of 28 sensing coil patterns 2514 are provided, four signal processors 2518 may be provided by way of example. In this case, one pair of signal processors 2518 may be disposed in a center area of a rear edge of the first layer 251a and adjacent to each other, while the other pair of signal processors 2518 may be disposed in a center area of a front edge of the first layer 251a and adjacent to each other.

For example, in an embodiment as illustrated in FIG. 7, a group of six sensing coil patterns 2514 which are arranged in the left side among the plurality of sensing coil patterns 2514 which are arranged in the left and right sides and are arranged in an area between a center line in a front-rear direction and the front edge of the first layer 251a, and 6 temperature sensors 2515 which are respectively arranged in the six sensing coil patterns 2514 may be allocated to a left signal processor 2518 among the pair of signal processors 2518 disposed at the front edge of the first layer 251a. A group of six sensing coil patterns 2514 which are arranged in the right side among the plurality of sensing coil patterns 2514 which are arranged in the left and right sides and are arranged in an area between the center line in a front-rear direction and the front edge of the first layer 251a, and 6 temperature sensors 2515 which are respectively arranged in the six sensing coil patterns 2514 may be allocated to a right signal processor 2518 among the pair of signal processors 2518 disposed at the front edge of the first layer 251a.

A group of sensing coil patterns 2514 and the temperature sensors 2515 may be allocated to the pair of signal processors 2518 disposed at the rear edge of the first layer 251a in the same manner as the allocation manner as described above.

As described above, the two pairs of signal processors 2518 are spaced from each other by the maximum spacing along the front-rear direction, such that the structure of each of the second lead pattern 2513b connecting the individual sensing coil patterns 2514 to the signal processor 2518 and the third lead pattern 2513c connecting the individual temperature sensor 2515 to the signal processor 2518 may be simplified and a length thereof may be minimized.

In addition, a low-power terminal (not shown) for signal transmission/reception and a board connector (not shown) mounted on the low-power terminal may be mounted together at each of the front edge and the rear edge of the first layer 251a and be disposed adjacent to each signal processor 2518 and may transmit an electrical signal output to the signal processor 2518 to the above-described main circuit board module 281.

In one example, as will be described later, the first lead pattern 2513a for transmitting high-frequency power to each of the first type pattern 2512a and the second type pattern 2512b constituting the working coil pattern 2512 may be disposed in the first layer 251a.

As shown, each first lead pattern 2513a may be constructed to be divided into a plurality of pattern strands.

Accordingly, the first lead pattern 2513a is divided into a plurality of pattern strands, so that power loss that may occur due to the skin effect when the high-frequency power is applied thereto may be minimized.

In one example, in consideration of the efficiency of power supply, the plurality of pattern strands may be coupled to each other at one end and the other end of the first lead pattern 2513a to form a common lead terminal 2513a1.

The common lead terminal 2513a1 formed at one end of the first lead pattern 2513a may be connected to the high-power terminal pattern 2516 formed at each of the front edge and the rear edge of the first layer 251a.

In one example, the first lead pattern 2513a may be disposed inside the first layer 251a and may extend from one end thereof and may extend toward the common lead terminal 2513a1 formed at the other end thereof.

In one example, in the present embodiment, the high-frequency power may be supplied to the pair of working coil patterns 2512 disposed adjacent to each other via three high-power terminal patterns 2516 and three first lead patterns 2513a.

That is, when the high-frequency power is supplied to each of the working coil patterns 2512 via the pair of high-power terminal patterns 2516 and the pair of first lead patterns 2513a, two pairs of high-power terminal patterns 2516 and two pairs of first lead patterns 2513a should be allocated to the pair of working coil patterns 2512.

In accordance with the present disclosure, the high-frequency power is supplied to the pair of working coil patterns 2512 via the three high-power terminal patterns 2516 and the three first lead patterns 2513a disposed adjacent to each other, so that the number of the high-power terminal patterns 2516 and the number of the first lead patterns 2513a may be minimized, and accordingly, the circuit configuration may be simplified.

This will be described in more detail with reference to FIG. 8.

FIG. 8 is a partially enlarged view of FIG. 7, and a detailed configuration of the high-power terminal pattern 2516 and the first lead pattern 2513a for supplying the power to the pair of working coil patterns 2512 disposed adjacent to each other and in a left rear side based on the state illustrated in FIG. 7 is illustrated.

Based on the illustrated state, the leftmost high-power terminal pattern 2516 is referred to as a first high-power terminal pattern 2516a, the middle high-power terminal pattern 2516 is referred to as a second high-power terminal pattern 2516b, and the rightmost high-power terminal pattern 2516 is referred to as a third high-power terminal pattern 2516c.

In addition, the first lead pattern 2513a connected to the first high-power terminal pattern 2516a will be referred to as a (1-1)th lead pattern 2513a-1, the first lead pattern 2513a connected to the second high-power terminal pattern 2516b will be referred to as a (1-2)th lead pattern 2513a-2, and the first lead pattern 2513a connected to the third high-power terminal pattern 2516c will be referred to as a (1-3)th lead pattern 2513a-3.

As illustrated, the first high-power terminal pattern 2516a may be electrically connected to an outer common terminal of one working coil pattern 2512 disposed further rearwardly of the other working coil pattern 2512 among the pair of working coil patterns 2512 via the (1-1)th lead pattern 2513a-1.

Hereinafter, the outer common terminal of the working coil pattern 2512 will be referred to as a second common terminal 2512a-3 and 2512b-3, and an inner common terminal of the working coil pattern 2512 will be referred to as a first common terminal 2512a-2 and 2512b-2.

As will be described later, the first common terminal 2512a-2 and 2512b-2 may include the first common terminal 2512a-2 of the first type pattern 2512a and the first common terminal 2512b-2 of the second type pattern 2512b. The first common terminal 2512a-2 of the first type pattern 2512a and the first common terminal 2512b-2 of the second type pattern 2512b may be connected in series to each other via a working coil via hole H_v1. As will be described later, the first common terminal 2512a of the first type pattern 2512a-2 and the first common terminal 2512b of the second type pattern 2512b-2 may be formed at positions vertically overlapping each other.

Similarly, the second common terminal 2512a-3 and 2512b-3 may include the second common terminal 2512a-3 of the first type pattern 2512a and the second common terminal 2512b-3 of the second type pattern 2512b. The second common terminal 2512a-3 of the first type pattern 2512a and the second common terminal 2512b-3 of the second type pattern 2512b may be connected in series to each other via the working coil via hole H_v1. As will be described later, the second common terminal 2512a-3 of the first type pattern 2512a and the second common terminal 2512b-3 of the second type pattern 2512b may be formed at positions vertically overlapping each other.

In this regard, the common lead terminal 2513a1 formed at the other end of the (1-1)th lead pattern 2513a-1 may be formed at a position vertically overlapping the second common terminal 2512a-3 and 2512b-3 of the working coil pattern 2512 disposed at the rear side, and may be connected in series with the second common terminal 2512a-3 and 2512b-3 of the working coil pattern 2512 via the working coil via hole H_v1.

As illustrated, the second high-power terminal pattern 2516b may be electrically connected to the second common terminal 2512a-3 and 2512b-3 of one working coil pattern 2512 disposed in front of the other working coil pattern 2512 among the pair of working coil patterns 2512 via the (1-2)th lead pattern 2513a-2.

In this regard, the common lead terminal 2513a1 formed at the other end of the first-second lead pattern 2513a-2 may be formed at a position vertically overlapping the second common terminal 2512a-3 and 2512b-3 of one working coil pattern 2512 disposed in front of the other working coil pattern 2512 among the pair of working coil patterns 2512, and may be connected in series with the second common terminal 2512a-3 and 2512b-3 of the working coil pattern 2512 via the working coil via hole H_v1.

In addition, the third high-power terminal pattern 2516c may be electrically connected to both the first common terminals 2512a-2 and 2512b-2 of the pair of working coil patterns 2512 via the (1-3)th lead pattern 2513a-3.

That is, as illustrated, the (1-3)th lead pattern 2513a-3 may have a common lead terminal 2513a1 formed at the other end thereof. A common lead terminal 2513a1 may be additionally provided at a middle position between one end and the other end of the (1-3)th lead pattern 2513a-3.

The common lead terminal 2513a1 formed at the other end of the (1-3)th lead pattern 2513a-3 may be electrically connected to the first common terminal 2512a-2 and 2512b-2 of one working coil pattern 2512 disposed in front of the other working coil pattern 2512 among the pair of working coil patterns 2512 via the working coil via hole H_v1.

In addition, the common lead terminal 2513a1 formed at the middle position of the (1-3)th lead pattern 2513a-3 may be electrically connected to the first common terminal 2512a-2 and 2512b-2 of one working coil pattern 2512 disposed in rear of the other working coil pattern 2152 among the pair of working coil patterns 2512 via the working coil via hole H_v1.

That is, the (1-3)th lead pattern 2513a-3 may be constructed to act as a common lead pattern capable of supplying the power to both the pair of working coil patterns 2512.

Accordingly, the pair of working coil patterns 2512 may be controlled to work as follows: When only the rear working coil pattern 2512 works, the power is supplied to the first high-power terminal pattern 2516a and the third high-power terminal pattern 2516c and power to the second high-power terminal pattern 2516b is cut off; When only the front working coil pattern 2512 works, the power is supplied to the second high-power terminal pattern 2516b and the third high-power terminal pattern 2516c and the power to the first high-power terminal pattern 2516a is cut off; or When both the pair of working coil patterns 2512 simultaneously work, the power is supplied to all of the first to third high-power terminal patterns 2516c.

In one example, based on the state illustrated in FIGS. 7 and 8, a plurality of edge notches 2517 may be formed at each of the front edge and the rear edge of the first layer 251a.

The edge notch 2517 serves to provide a coupling space which a connector (not shown) for supplying the high frequency power to the high-power terminal pattern 2516 may be fitted into.

As shown, the individual high-power terminal patterns 2516 may be arranged in a divided manner while the edge notch 2517 is interposed between adjacent ones thereof such that the connector may be connected to the high-power terminal pattern 2516 while the connector is fitted into the edge notch 2517.

As described above, the edge notch 2517 serves to provide a space to which a connector to be described later may be coupled. Accordingly, the edge notch 2517 may be referred to as a connector coupling portion, an edge portion, a cut-away, an opening, or the like, in consideration of a function and a shape thereof. In order to reduce a manufacturing cost via component commonization, the connectors having the same shape and the same structure may be respectively fitted to the edge notches 2517. To this end, the edge notches 2517 may be formed to have the same shape and the same size.

In one example, as illustrated in FIG. 9, the edge notch 2517 may extend through the first layer 251a to the twelfth layer 2511 of the first coil circuit board module 251.

In addition, a screw hole H_sc may be formed so as to extend through the first coil circuit board module 251. The screw hole H_sc may be formed to extend through the first layer 251a to the twelfth layer 2511 in the same manner as the edge notch 2517 does.

A fastening means such as a screw bolt which is not shown may pass through the screw hole H_sc and be coupled to the above-described board supporter 26. Thus, the first coil circuit board module 251 may be firmly fastened to the above-described board supporter 26.

By way of example, the screw hole H_sc may be disposed at each of four corners so as not to interfere with the patterns constituting the first coil circuit board module 251.

In addition, a ground terminal for grounding the first coil circuit board module 251 may be formed in the first layer 251a and around the screw hole H_sc.

The first coil circuit board module 251 may have a light-transmission slit hole H_sl formed therein to extend through the first layer 251a to the twelfth layer 2511.

The above-described light source module 23 may be disposed under the light-transmission slit hole H_sl, and the visible light generated from the light source module 23 may travel through the light-transmission slit hole H_sl and then be irradiated to the lower surface of the top plate 21. Accordingly, the display line L extending linearly may be displayed in the top plate 21.

In order to implement the display line L extending linearly, the light-transmission slit hole H_sl may extend linearly in a shape corresponding to the shape of the display line L.

However, as illustrated in FIG. 7, in order to prevent the rigidity of the first coil circuit board module 251 from being rapidly degraded, the light-transmission slit hole H_sl may be divided into a plurality of divided holes, and the divided light-transmission slit holes H_sl may be linearly arranged.

In addition, a connection portion connecting the divided light-transmission slit holes H_sl to each other may be provided between the divided light-transmission slit holes H_s1.

The light-transmission slit hole H_sl may be formed in a process of punching a corresponding portion after an entire stacking process of the circuit board module has been completed.

Alternatively, in order to project the visible light generated from the light source module 23, two coil circuit board modules may be disposed to be spaced apart from each other so that a predetermined gap is formed between the two coil circuit board modules entirely isolated from each other. Accordingly, a separate punching process or a separate slit hole process on the coil circuit board module may be omitted.

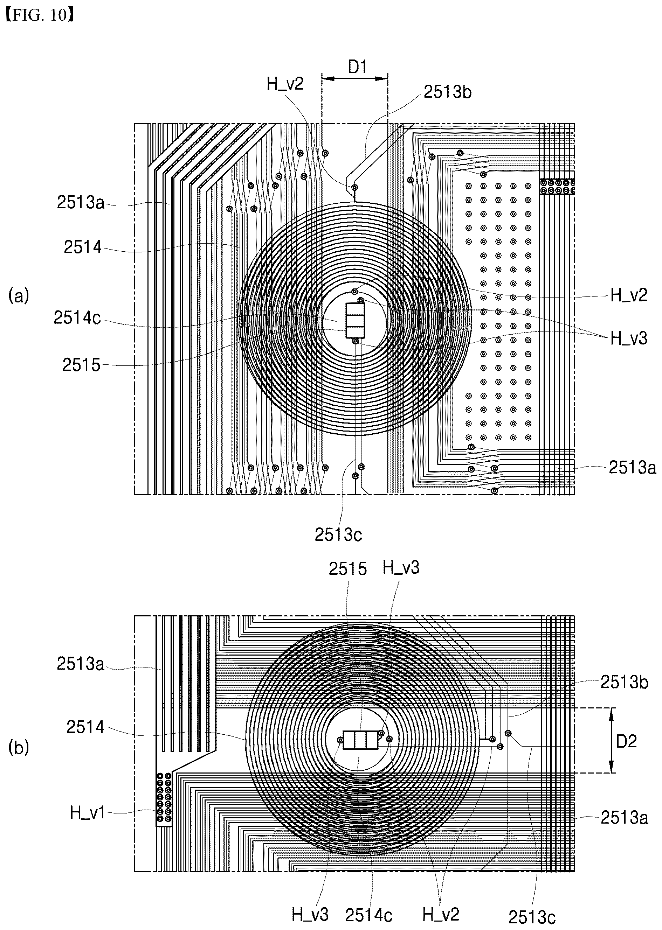

Hereinafter, a relative arrangement position of the sensing coil pattern 2514 and an arrangement and arrangement structure of the temperature sensor 2515 will be described with reference to FIG. 10.

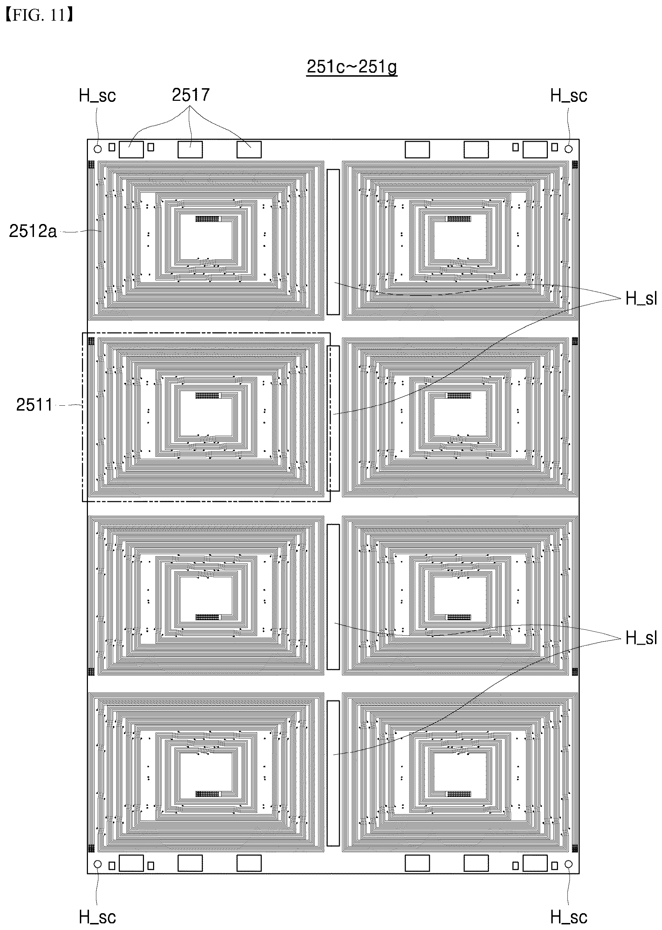

FIG. 10 is a partially enlarged top view of the illustrated first coil circuit board module 251. In FIG. 11, the sensing coil pattern 2514 and the working coil pattern 2512 are shown together with each other for the purpose of description and understanding of relative positions. However, in the present embodiment, because the sensing coil pattern 2514 and the working coil pattern 2512 are actually disposed at different layers, both the sensing coil pattern 2514 and the working coil pattern 2512 may not be observed at the same time.

As described above, the individual sensing coil patterns 2514 wound in the circular spiral shape may be disposed so as to partially overlap the working coil pattern 2512 wound in the quadrilateral spiral shape along the vertical direction.

In this regard, each of some of the plurality of sensing coil patterns 2514 may be entirely disposed inside the single burner 2511 composed of the working coil pattern 2512, while each of the others of the plurality of sensing coil patterns 2514 may be disposed across the pair of adjacent burners 2511.

(a) in FIG. 10 illustrates a state in which the sensing coil pattern 2514 is entirely disposed inside the working coil pattern 2512, and (b) in FIG. 10 illustrates a state in which the sensing coil pattern 2514 is disposed across a pair of adjacent working coil patterns 2512.

First, as will be described later, the working coil pattern 2512 formed by stacking the plurality of first type patterns 2512a and the plurality of second type patterns 2512b may be wound a plurality of times to have a quadrilateral spiral shape.

For example, each of the first type patterns 2512a and the second type patterns 2512b constituting the working coil pattern 2512 may be wound a total of nine times. That is, the working coil pattern 2512 may be wound to have 9 turns. In this regard, each of the individual turns of each of the first type pattern 2512a and the second type pattern 2512b may be defined to mean a state in which a coil is wound one round in a spiral manner. That is, the nine turns may mean a state in which each of the first type pattern 2512a and the second type pattern 2512b is spirally wound nine turns or nine windings.

In addition, for example, six to five pattern strands 2512a-1 and 2512b-1 may be bundled with each other to form one bundle which is wound.

In this regard, as illustrated, a spacing between adjacent ones of the turns constituting each of the first type pattern 2512a and the second type pattern 2512b may be maintained to be substantially constant. However, a horizontal spacing between the third turn and the fourth turn may be much larger than a horizontal spacing between adjacent ones of the other turns.

The area corresponding to the relatively larger horizontal spacing may constitute an inner clearance D1.

In addition, an outer clearance D2 as a front-rear clearance similar to the inner clearance D1 may be formed between the pair of working coil patterns 2512 disposed adjacent to each other in the front-rear direction based on a state in which the first coil circuit board module 251 is disposed as illustrated in (b) in FIG. 10.

The inner clearance D1 and the outer clearance D2 may be formed to have the same size, and for example, each of the inner clearance D1 and the outer clearance D2 may be a range of 3.8mm to 4.2mm, and preferably 4 mm.

As illustrated, the sensing coil pattern 2514 may be disposed such that the center point thereof is located in each of the inner clearance D1 and the outer clearance D2.

Preferably, when the center point of the sensing coil pattern 2514 is located in the inner clearance D1 as shown in (a) in FIG. 10, the center point of the sensing coil pattern 2514 may approximately coincide with a middle position of an area between the third turn and the fourth turn.

In addition, preferably, when the center point of the sensing coil pattern 2514 is located in the outer clearance D2 as shown in (b) in FIG. 10, the center point of the sensing coil pattern 2514 may approximately coincide with a middle position of an area between the pair of working coil patterns 2512 disposed adjacent thereto.

In addition, as described above, each of the first sensing coil pattern 2514a and the second sensing coil pattern 2514b has an area in which no pattern is formed. Thus, a first central inner area 2514c may be formed inwardly of the sensing coil pattern 2514.

As illustrated, the first central inner area 2514c of the sensing coil pattern 2514 may have a disk shape, and a diameter of the disk-shaped inner area may be equal to or slightly smaller than a size of each of the inner clearance D1 and the outer clearance D2.

A combination of the inner clearance D1 and the outer clearance D2 of the working coil pattern 2512 and the first central inner area 2514c of the sensing coil pattern 2514 may provide a space in which the temperature sensor 2515 may be mounted.

As illustrated, the temperature sensor 2515 for sensing the temperature of the top plate 21 may be mounted in the first layer 251a and in the first central inner area 2514c of each sensing coil pattern 2514. In this regard, the size of each of the inner clearance D1 and the outer clearance D2 and the diameter of the sensing coil pattern 2514 may be larger than a size of the temperature sensor 2515, that is, a longitudinal width thereof.

Accordingly, when being viewed from the top plate 21, the individual temperature sensor 2515 may be disposed in the first layer 251a and in the first central inner area 2514c as surrounded with each sensing coil pattern 2514.

In addition, the temperature sensor 2515 may be disposed at a position vertically non-overlapping the sensing coil pattern 2514 and in the first central inner area 2514c so that interference between the temperature sensor 2515 and the sensing coil pattern 2514 does not occur.

In one example, in an example, the temperature sensor 2515 may be embodied as a surface mounted devices (SMD) type sensor in a form of a chip that is relatively small, easily mounted in the first layer 251a, and has excellent sensing capability.

The SMD-type temperature sensor 2515 may include, for example, a sensor body, a thermistor disposed in the sensor body, and a pair of electrodes exposed to an upper end surface of the first coil circuit board module 251.

The temperature sensor 2515 may be mounted on the upper end surface of the first coil circuit board module 251. That is, the temperature sensor 2515 may be attached and fixed to the upper end surface of the first coil circuit board module 251.

More specifically, a pair of conductive sensor pads (not shown) for attaching the temperature sensor 2515 may be disposed in the first coil circuit board module 251, and the pair of electrodes of the temperature sensor 2515 may be attached to the pair of sensor pads, respectively.

In this regard, the pair of electrodes of the temperature sensor 2515 may be electrically connected and attached to the corresponding pair of sensor pads using various physical and chemical methods, such as welding, soldering, and adhesive, respectively.

However, when the SMD-type temperature sensor 2515 is mounted on and attached to the upper end surface of the first coil circuit board module 251, there is a high possibility that the SMD type temperature sensor 2515 is affected by heat generated from the working coil pattern 2512.

In order that the influence of the heat generation from the working coil pattern 2512 on the SMD-type temperature sensor may be minimized, it is necessary for the SMD-type temperature sensor to be positioned as far as possible from the working coil pattern 2512 along the horizontal direction.

A position of the SMD-type temperature sensor at which the influence of the heat generation thereon may be minimized may be selected from an area in which the first central inner area 2514c of the sensing coil pattern 2514 and the inner clearance D1 overlap each other, and an area in which the first central inner area 2514c of the sensing coil pattern 2514 and the outer clearance D2 overlap each other.

Although FIG. 10 illustrates that the temperature sensor 2515 is disposed at a position at which a center point of the temperature sensor 2515 and a center point of the first central inner area 2514c of the sensing coil pattern 2514 substantially coincide with each other, this is merely an example. The influence of heat generation from the working coil pattern 2512 on the temperature sensor 2515 may be minimized merely by positioning the temperature sensor 2515 at any position in each of the area in which the first central inner area 2514c of the sensing coil pattern 2514 and the inner clearance D1 overlap each other and the area in which the first central inner area 2514c of the sensing coil pattern 2514 and the outer clearance D2 overlap each other.

In addition, the temperature sensor 2515 may be disposed in each of the area in which the first central inner area 2514c of the sensing coil pattern 2514 and the inner clearance D1 overlap each other, and the area in which the first central inner area 2514c of the sensing coil pattern 2514 and the outer clearance D2 overlap each other, so that a space in which the third lead pattern 2513c electrically connecting the temperature sensor 2515 to the signal processor 2518 and a temperature sensor via hole H_v3 via which the temperature sensor 2515 and the third lead pattern 2513c are connected to each other are installed may be effectively secured.

In this regard, as described above, the SMD-type temperature sensor 2515 may have a first electrode and a second electrode constituting a pair of electrodes respectively formed at both opposing ends in the longitudinal direction thereof. The first layer 251a may include a pair of sensor pads respectively soldered to the first electrode and the second electrode.

As illustrated, in the present embodiment, a direction in which the first electrode and the second electrode respectively provided at both opposing ends of the temperature sensor 2515 are arranged to be spaced apart from each other may be parallel to the extending direction of the working coil pattern 2512 disposed adjacent to the temperature sensor 2515 or may intersect the extending direction of the working coil pattern 2512.

That is, when, as shown in (a) in FIG. 10, the temperature sensor 2515 is disposed in the area of the first clearance D1, the individual pattern strands 2512a-1 and 2512b-1 of the working coil pattern 2512 disposed adjacent to one side of the temperature sensor 2515 may extend in the front-rear direction. Accordingly, the direction in which the first electrode and the second electrode of the temperature sensor 2515 disposed in the area of the first clearance D1 are arranged to be spaced apart from each other may be the front-rear direction or the left-right direction intersecting the front-rear direction.

In addition, when, as illustrated in (b) in FIG. 10, the temperature sensor 2515 is disposed in the area of the second clearance D2, the individual pattern strands 2512a-1 and 2512b-1 of each of the working coil patterns 2512 respectively disposed adjacent to both opposing sides of the temperature sensor 2515 may extend along the left-right direction. Accordingly, the direction in which the first electrode and the second electrode of the temperature sensor 2515 disposed in the area of the second clearance D2 are arranged to be spaced apart from each other may be the left-right direction or the front-rear direction intersecting the left-right direction.

In this regard, a pair of sensor pads respectively corresponding to the first electrode and the second electrode of the temperature sensor 2515 disposed in the area of the first clearance D1 may be arranged in the same direction as the direction in which the first electrode and the second electrode thereof are arranged. A pair of sensor pads respectively corresponding to the first electrode and the second electrode of the temperature sensor 2515 disposed in the area of the second clearance D2 may be arranged in the same direction as the direction in which the first electrode and the second electrode thereof are arranged.

Accordingly, the third lead pattern 2513c for transmitting the electrical signal generated from the temperature sensor 2515 to the signal processor 2518 may extend toward the signal processor 2518 without interference thereof with the working coil pattern 2512 or in a state in which interference thereof with the working coil pattern 2512 is minimized.

More specifically, a portion of the third lead pattern 2513c which overlaps the sensing coil pattern 2514 and extends across the sensing coil pattern 2514 may be disposed in one of the third to seventh layers 251c, 251d, 251e, 251f, and 251g in which the first type pattern 2512a is formed, or may be disposed in one of the eighth to twelfth layers 251h, 251i, 251j, 251k, and 2511 in which the second type pattern 2512b is formed.

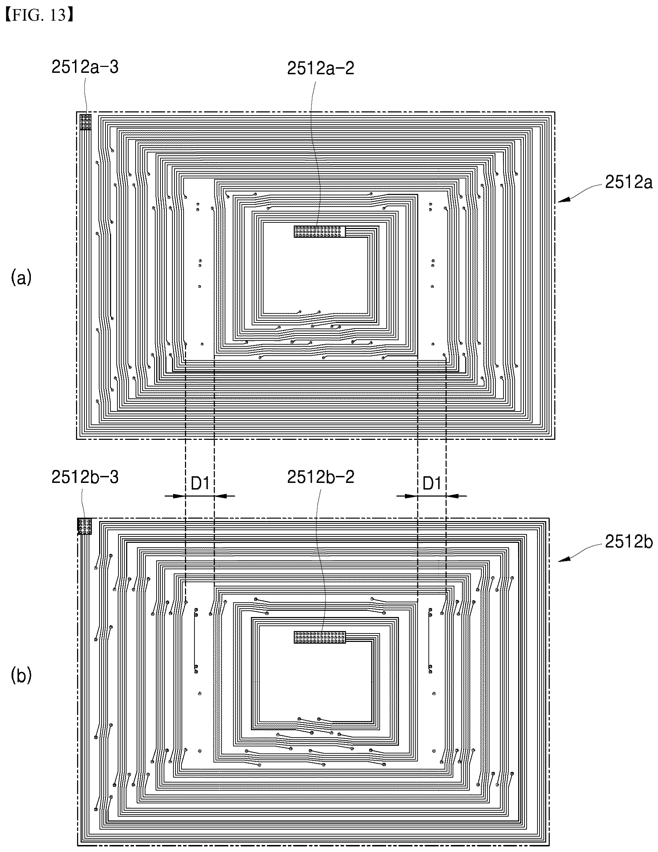

For example, in the present embodiment, as illustrated in FIG. 13, the third lead pattern 2513b may be provided in one of the eighth to twelfth layers 251h, 251i, 251j, 251k, and 2511 in which the second type pattern 2512c is formed, and the third lead pattern 2513c formed in one of the eighth to twelfth layers 251h, 251i, 251j, 251k, and 2511 may extend in a parallel manner to the pattern strands 2512b-1 of the second type pattern 2512b while being disposed in each of the first clearance D1 and the second clearance D2.

Accordingly, the third lead pattern 2513c may extend so as to effectively bypass the working coil pattern 2512.

The remaining portion of the third lead pattern 2513c may be disposed in the first layer 251a or the second layer 251b in which interference thereof with the working coil pattern 2512 does not occur, as shown in FIGS. 9 and 10.

Hereinafter, a detailed configuration of each of the first type pattern 2512a and the second type pattern 2512b constituting the working coil pattern 2512 will be described with reference to FIGS. 11 to 16.

FIG. 11 illustrates a structure in a plan view of the third layer 251c of the first coil circuit board module 251 having a multilayer structure.

A configuration of the third layer 251c of the first coil circuit board module 251 described below may be equally applied to each of the fourth to seventh layers 251d, 251e, 251f, and 251g unless otherwise specified.

Referring to FIG. 11, the first type patterns 2512a of eight working coil patterns 2512 respectively constituting eight burners 2511 may be arranged in the third layer 251c of the first coil circuit board module 251.

As illustrated, one first type pattern 2512a may be allocated to one burner 2511. The first type patterns 2512a may have the same size so that the individual burners 2511 may have the same size.

In this regard, for example, the eight burners 2511 may be arranged in a lattice shape, and accordingly, the first type patterns 2512a may be arranged in a lattice shape.

Accordingly, the first type patterns 2512a are arranged in the lattice shape and each of the first type patterns 2512a may be constructed to be wound in the quadrilateral spiral shape, such that heating areas may be evenly arranged inside the third layer 251c.

In one example, when the plurality of first type patterns 2512a are arranged in the lattice shape as described above, the first type patterns 2512a may be arranged in a symmetrical manner.

That is, the plurality of first type patterns 2512a may be arranged in a left-right symmetrical manner with each other around the light-transmission slit hole H_sl serving as a center line in the left-right direction of the third layer 251c.

In addition, the plurality of first type patterns 2512a may be arranged in a front-rear symmetrical shape with each other around the front-rear center line of the third layer 251c. Based on the illustrated embodiment, a front-rear center line of the third layer 251c may be defined as a virtual horizontal line around which a total of eight burner 2511 are divided into front four burners 2511 and rear four burners 2511 in a front-rear direction.

Since the plurality of first type patterns 2512a are arranged in the symmetrical manner with each other, a length of the first lead pattern 2513c for supplying the high-frequency power to the individual third layer 251a may be minimized, and the structure of the first lead pattern 2513a may be simplified.

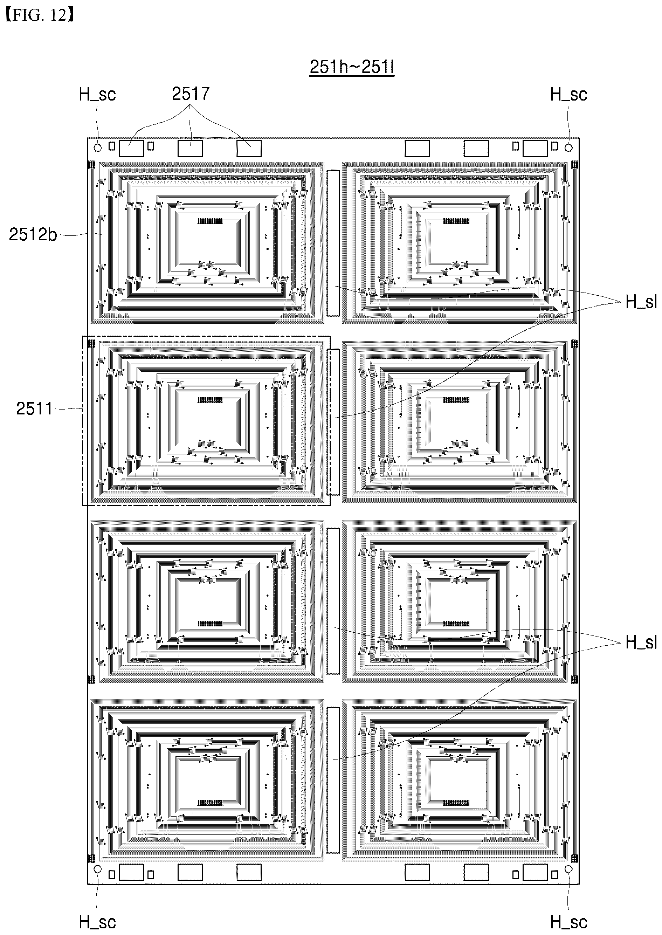

FIG. 12 illustrates a structure in a plan view of the eighth layer 251h of the first coil circuit board module 251 having a multilayer structure.

A configuration of the eighth layer 251h of the first coil circuit board module 251 described below may be equally applied to each of the ninth to twelfth layers 251i, 251j, 251k, and 2511 unless otherwise specified.

As illustrated in FIG. 12, the second type patterns 2512b of 8 working coil patterns 2512 respectively constituting eight burners 2511 may be arranged in the eighth layer 251h of the first coil circuit board module 251.

As illustrated, one second type pattern 2512b may be allocated to one burner 2511. The second type patterns 2512b may have the same size so that the individual burners 2511 may have the same size.

In this regard, in the similar manner to the first type pattern 2512a, the second type patterns 2512b may be arranged in a lattice shape.

In addition, in the similar manner to the first type pattern 2512a as described above, the plurality of second type patterns 2512b may be arranged in a left-right symmetrical manner each other around the light-transmission slit hole H_sl, and the plurality of second type patterns 2512b may be arranged in a front-rear symmetrical manner with each other around the center line in the front-rear direction of the eighth layer 251h.

FIG. 13 shows the first type pattern 2512a and the second type pattern constituting one same burner 2511.

The first type patterns 2512a and the second type patterns 2512b illustrated in FIG. 13 may be arranged in a multi-layer structure along the vertical direction as described above so as to constitute the same burner 2511.

As illustrated in FIG. 13, each of the first type pattern 2512a and the second type pattern 2512b constituting the working coil pattern 2512 may be wound in the quadrilateral spiral shape and extend from the first common terminal 2512a-2 and 2512b-2 as the inner common terminal toward the second common terminal 2512a-3 and 2512b-3 as the outer common terminal.

For example, each of the first type pattern 2512a and the second type pattern 2512b may be wound a total of nine windings while extending from the first common terminal 2512a-2 and 2512b-2 to the second common terminal 2512a-3 and 2512b-3. That is, each of the first type pattern 2512a and the second type pattern 2512b may be wound so as to have nine turns.

As illustrated, the first common terminal 2512a-2 and 2512b-2 may be formed at a position eccentric in an outward direction from a center of the burner 2511. That is, an area in which the first type pattern 2512a and the second type pattern 2512b are not formed may be formed in a center of the burner 2511. This is to prevent overheating that may occur when heat generated from the individual pattern strands 2512a-1 and 2512b-1 is concentrated on the center of the burner 2511. Although not shown, a means for preventing overheating of the central area of the burner 2511 may be additionally provided in a form of a via hole in the central area of the burner 2511.

In addition, as described above, while the spacing between adjacent ones of the turns constituting each of the first type pattern 2512a and the second type pattern 2512b is maintained to be substantially constant, the inner clearance D1 in which the temperature sensor 2515 is disposed may be formed between the third turn and the fourth turn.

For example, the first type pattern 2512a may have six pattern strands 2512a-1 bundled with each other to form one turn, and the second type pattern 2512b may have five pattern strands 2512b-1 bundled with each other to form one turn.

Widths of the individual pattern strands 2512a-1 and 2512b-1 constituting each of the first type pattern 2512a and the second type pattern 2512b may be equal to each other and may be in a range of 0.27mm to 0.33mm, preferably 0.3mm.

In this regard, in the first type pattern 2512a, a total of six individual pattern strands 2512a-1 constitute one turn. However, the first type pattern 2512a does not extend from the first turn to the ninth turns only using the six individual pattern strands 2512a-1.

Likewise, in the second type pattern 2512b, a total of five individual pattern strands 2512b-1 constitute one turn. However, the second type pattern 2512b does not extend from the first turn to the ninth turn only using the five individual pattern strands 2512b-1.

That is, while the first type pattern 2512a extends from the first turn to the ninth turn, one turn has been completed, and then, in the next turn, one of the six individual pattern strands 2512a-1 may be terminated, and a new individual pattern strand 2512a-1 may extend. In this way, each of the plurality of pattern strands 2512a-1 may extend in a divided manner.

Similarly, while the second type pattern 2512b extends from the first turn to the ninth turn, one turn has been completed, and then, in the next turn, one of the five individual pattern strands 2512b-1 may be terminated, and a new individual pattern strand 2512b-1 may extend. In this way, each of the plurality of pattern strands 2512b-1 may extend in a divided manner.

As described above, the first type pattern 2512a may be composed of the plurality of individual pattern strands 2512a-1 extending in the divided manner. The second type pattern 2512b may be composed of the plurality of individual pattern strands 2512b-1 extending in the divided manner. Thus, the wires may be bundled with each other in a similar manner to the Litz wire applied to the conventional cooktop.

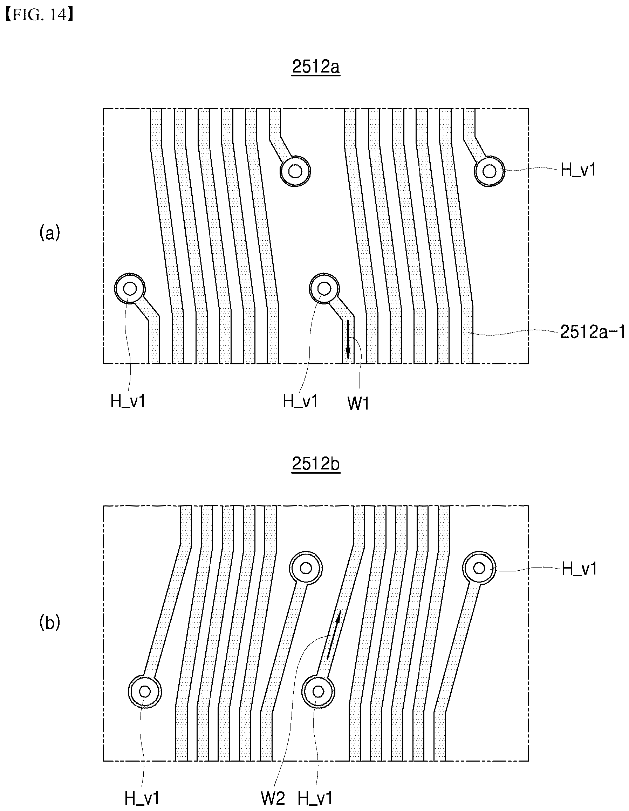

In this regard, as illustrated in FIG. 14, the start point and the end point of the individual pattern strands 2512a-1 of the first type pattern 2512a arranged to constitute a new turn and the start point and the end point of the individual pattern strands 2512b-1 of the second type pattern 2512b arranged to constitute a new turn may be connected in series with each other via the working coil via holes H_v1, respectively.

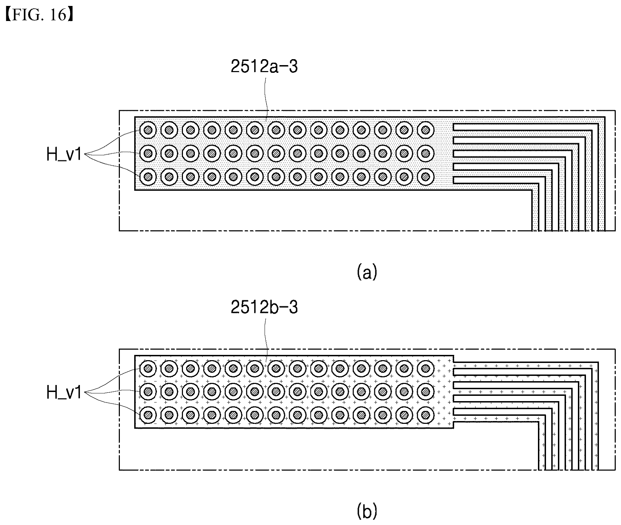

In this regard, each of the working coil via holes H_v1 respectively connecting the start point and the end point of the individual pattern strands 2512a-1 of the first type pattern 2512a to the start point and the end point of the individual pattern strands 2512b-1 of the second type pattern 2512b may extend entirely from the third layer 251c to the twelfth layer 2511 as shown in FIG. 16 to collectively connect the individual pattern strands 2512a-1 and 2512b-1 disposed in all of the layers to each other.

However, as illustrated in FIG. 14, the direction in which the individual pattern strands 2512a-1 constituting the first type pattern 2512a extend and the direction in which the individual pattern strands 2512b-1 constituting the second type pattern 2512b extend may be opposite to each other.

For example, the individual pattern strands 2512a-1 constituting the first type pattern 2512a may extend in a first direction W1, while the individual pattern strands 2512b-1 constituting the second type pattern 2512b may extend in a second direction W2 opposite to the first direction W1.

For example, as illustrated, the first direction W1 may be a clockwise direction, and the second direction W2 may be a counterclockwise direction.

Accordingly, when the high frequency power is supplied via the same working coil via hole H_v1, currents having opposite flow directions may flow through the individual pattern strands 2512a-1 of the first type pattern 2512a and the individual pattern strands 2512b-1 of the second type pattern 2512b which are simultaneously electrically connected to the same working coil via hole H_v1, and thus, magnetic fields may be generated in opposite directions from the first type pattern 2512a and the second type pattern 2512b.

As described above, the magnetic fields in the opposite directions are respectively generated from the first type pattern 2512a and the second type pattern 2512b, such that the dispersion effect of the magnetic field may be generated similarly to the conventional Litz wire constructed in a twisted shape.

Accordingly, the magnetic fields generated from the first type pattern 2512a and the second type pattern 2512b are uniformly transmitted to the container without being concentrated on a specific portion of the container, thereby improving heating efficiency and heating effect of the container.

In one example, as illustrated in FIG. 16, a plurality of working coil via holes H_v1 may be formed in each of the first common terminal 2512a-2 of the first type pattern 2512a and the first common terminal 2512b-2 of the second type pattern 2512b in order to minimize loss due to resistance.

Each of the plurality of working coil via holes H_v1 may be formed to extend through the first layer 251a to the twelfth layer 251a so as to be electrically connected to the first lead pattern 2513a formed in the first layer 2511.

As the common working coil via hole H_v1 is formed so as to extend through all of the layers, the heat generated from the individual working coil pattern 2512 may be effectively discharged from the first coil circuit board module 251 through the working coil via hole H_v1. That is, the working coil via hole H_v1 may act as a ventilation hole for preventing overheating of the first coil circuit board module 251.

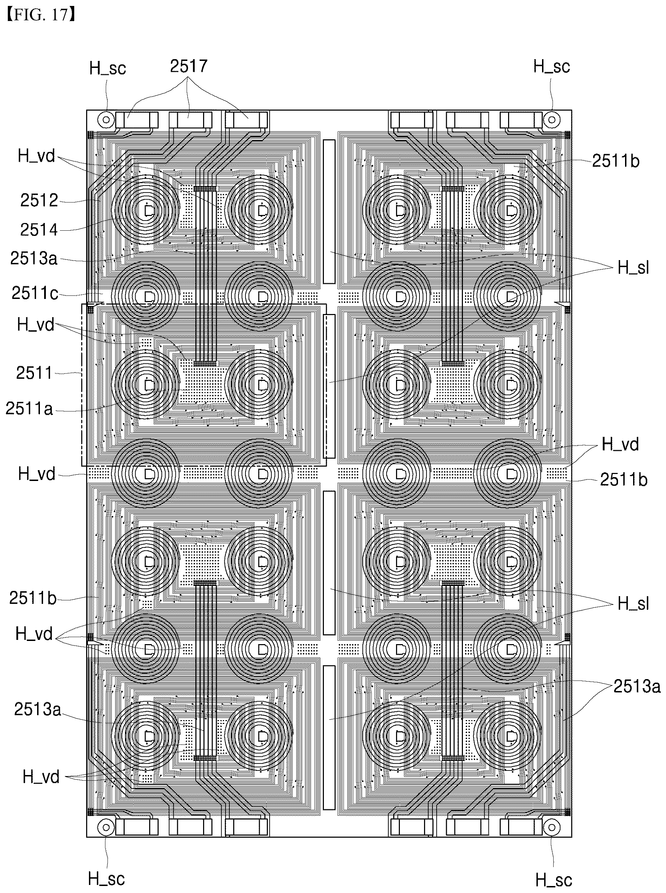

Although not shown in FIG. 17, in the similar manner to the first common terminal 2512a-2 and 2512b-2, a plurality of working coil via holes H_v1 may be formed in each of the second common terminal 2512a-3 of the first type pattern 2512a and the second common terminal 2512b-3 of the second type pattern 2512b so as to extend through the first layer 251a to the twelfth layer 251l.

### [Detailed structure of dummy via hole and dummy pattern]

Hereinafter, detailed configurations of the dummy via hole H_vd and the dummy pattern 2519 provided in the first coil circuit board module 251 according to the present disclosure will be described with reference to FIGS. 17 to 26.

First, FIGS. 17 to 21 illustrate a configuration in which the dummy via hole H_vd is formed in the first coil circuit board module 251 according to a first embodiment of the present disclosure.

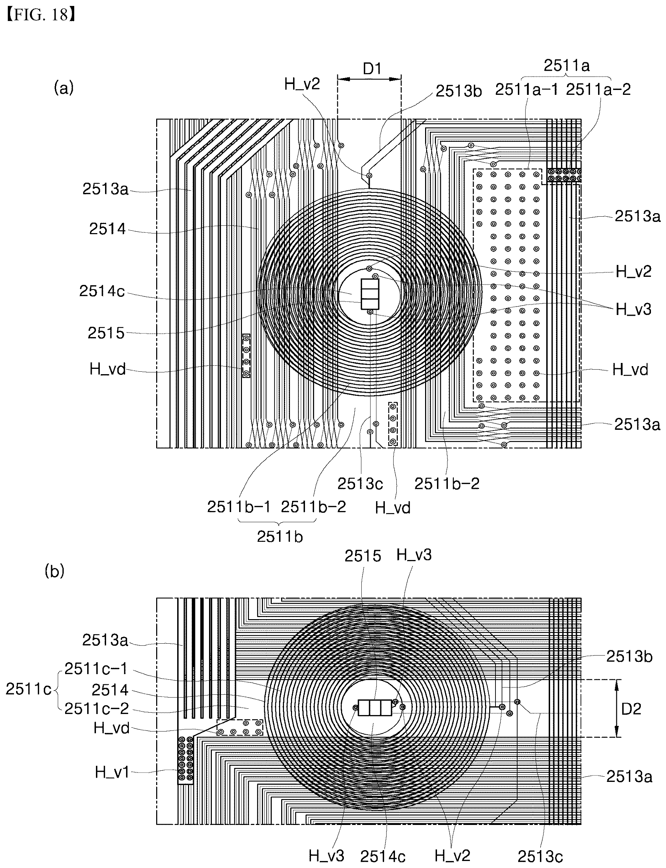

Referring to FIGS. 17 and 18, a central inner area 2512a-1 in which the pattern strands 2512a-1 and 2512b-1 constituting the working coil pattern 2512 are not formed may be formed inside the working coil pattern 2512 constituting the first coil circuit board module 251.

In order to distinguish the central inner area of the working coil pattern 2512 from the first central inner area 2514c of the sensing coil pattern 2514, hereinafter, the central inner area of the working coil pattern 2512 will be referred to as a second central inner area 2511a.

As described above, when the high frequency power is applied to the working coil pattern 2512 to heat the container, each of the pattern strands 2512a-1 and 2512b-1 acts as a resistor, and thus a considerable amount of heat is generated therefrom.

In particular, when the working coil pattern 2512 is wound in a spiral shape as in the present embodiment, it is highly likely that the second central inner area 2511a on which the heats respectively generated from the plurality of pattern strands 2512a-1 and 2512b-1 are concentrated has the highest temperature distribution, and accordingly, there is a high possibility that eddy current loss of the working coil pattern 2512 occurs.

In order to prevent overheating and eddy current loss of the first coil circuit board module 251 due to the concentration of the heat, the first coil circuit board module 251 constituting the cooktop 20 of the cooking appliance 1 according to the first embodiment of the present disclosure may be constructed to have the second central inner area 2511a in which the pattern strands 2512a-1 and 2512b-1 are not formed.

However, since the pattern strands 2512a-1 and 2512b-1 are not formed in the second central inner area 2511a inside the working coil pattern 2512, an area filled with only an electrical insulating material made of a prepreg, specifically, FR-4, as described above occurs.

In particular, when the working coil pattern 2512 has a total of 10 layers arranged along the vertical direction to constitute the individual burner 2511 as in the embodiment, the area filled with only the electrical insulating material may be formed while the working coil pattern 2512 is not formed in an entire are of each of the 10 layers.

In this case, as illustrated in FIGS. 17 and 18, when the sensing coil pattern 2514 or the lead pattern 2513 formed in the layers in which the working coil pattern 2512 is not formed, that is, the first layer 251a and the second layer 251b based on the embodiment, is disposed to partially overlap the second central inner area 2511a, the second central inner area 2511a may be divided into an overlapping area 2511a-1 in which the patterns overlap each other in the vertical direction and a non-overlapping area 2511a-2 in which the patterns non-overlap each other in the vertical direction.

In addition, in a similar manner to the second central inner area 2511a, an inter-turn area 2511b formed between the turns of the working coil pattern 2512 disposed adjacent to each other may be divided into an overlapping area 2511b-1 and a non-overlapping area 2511b-2, and an inter-coil area 2511c formed between the working coil patterns 2512 constituting different burners 2511 may be divided into an overlapping area 2511c-1 and a non-overlapping area 2511c-2.

Each of these non-overlapping areas 2511a-2, 2511b-2, and 2511c-2 may be made only of the electrical insulating material and be free of the pattern while the first coil circuit board module 251 extends from the first layer 251a to twelfth layer 251l, that is, from the upper end surface 251t to the lower end surface 251v of the first coil circuit board module 251.

Accordingly, the non-overlapping area has a multilayer structure in which all of the layers are made only of the electrical insulating material and free of the patterns as the first coil circuit board module 251 extends from the upper surface 251t to the lower surface 251v. Thus, the rigidity is significantly weakened in the non-overlapping area, and thus the non-overlapping area 2511a-2 of the second central inner area 2511a is highly likely to be thermally deformed due to the heat generation of the working coil pattern 2512. Further, the non-overlapping area 2511a-2 is filled only with the prepreg, thereby increasing the manufacturing cost.

In order to maximally suppress the thermal deformation due to the decrease in the rigidity of the first coil circuit board module 251 and to reduce the increase in the manufacturing cost, as shown in FIGS. 17 and 18, at least one via hole H_vd electrically insulated from other patterns such as the working coil pattern 2512 and the sensing coil pattern 2514 may be disposed in each of the non-overlapping areas 2511a-2, 2511b-2, and 2511c-2.

As described above, the at least one via hole H_vd provided in each of the non-overlapping areas 2511a-2, 2511b-2, and 2511c-2 may be referred to as a dummy via hole H_vd in that it is formed in a state of being electrically insulated from other patterns and does not have the purpose of power supply or signal transmission. Hereinafter, the via hole provided in each of the non-overlapping areas 2511a-2, 2511b-2, and 2511c-2 will be referred to as the dummy via hole H_vd.

Since the dummy via hole H_vd is disposed in the non-overlapping area 2511a-2 of the first coil circuit board module 251, the dummy via hole H_vd is disposed not to contact or overlap other patterns including the working coil pattern 2512, the sensing coil pattern 2514, and the lead pattern 2513 in the vertical direction.

Accordingly, when viewed from the top plate 21, the dummy via hole H_vd may be disposed to entirely belong to each of the non-overlapping area 2511a-2 of the second central inner area 2511a, the non-overlapping area 2511c-2 of the inter-coil area 2511c, and the non-overlapping area 2511b-2 of the inter-turn area 2511b.

In addition, as illustrated in FIG. 17, the dummy via hole H_vd is disposed not to be in contact with or overlap other patterns including the working coil pattern 2512 in the vertical direction, shapes and sizes of the non-overlapping area 2511a-2 of the second central inner area 2511a, the non-overlapping area 2511c-2 of the inter-coil area 2511c, and the non-overlapping area 2511b-2 of the inter-turn area 2511b may be different from each other or irregular depending on the positions thereof. Thus, as illustrated, the shapes in which the dummy via holes H_vd are respectively arranged in the non-overlapping areas 2511a-2, 2511b-2, and 2511c-2 may be different from each other or irregular based on the positions thereof.

In this regard, the irregularity means that the positions and/or the numbers of the dummy via holes H_vd may be arranged and/or distributed in a point asymmetry or line asymmetry shape around a center point of the individual working coil pattern 2512 or a straight line extending across the center point thereof. This is because the shape or arrangement of the working coil pattern 2512 and the shape or arrangement of the sensing coil pattern 2514 are asymmetric, and each of the individual working coil pattern 2512 and the individual sensing coil pattern 2514 has a terminal or an end, and the lead pattern 2513 travels across an area between the adjacent working coil patterns 2512 and an area between the adjacent sensing coil patterns 2514. Accordingly, the arrangement of the dummy via holes H_vd may also be asymmetric.

In addition, the dummy via hole H_vd is disposed so as not to contact conductors such as the working coil pattern 2512 and the sensing coil pattern 2514, the heat dissipation performance of the first coil circuit board module 251 may be improved while the dummy via hole H_vd does not interfere with the electrical conduction of the working coil pattern 2512 and the sensing coil pattern 2514.

As described above, the cooktop of the present disclosure includes the working coil via hole H_v1 for supplying power to the working coil pattern 2512 having the multilayer structure, the sensing coil via hole H_v2 for transmitting an output signal of the sensing coil pattern 2514, and the temperature sensor via hole H_v3 for transmitting an output signal of the temperature sensor 2515.

The dummy via hole H_vd may be constructed to have the same shape and size as those of each of the working coil via hole H_v1, the sensing coil via hole H_v2, and the temperature sensor via hole H_v3.

Therefore, the dummy via hole H_vd may be subject to the same machining process as a machining process for forming the working coil via hole H_v1, the sensing coil via hole H_v2, and the temperature sensor via hole H_v3 without changing the settings of the manufacturing equipment for forming the functional via holes such as the working coil via hole H_v1, the sensing coil via hole H_v2, and the temperature sensor via hole H_v3 and changing the manufacturing equipment. Thus, the increase in the manufacturing cost and manufacturing time for additionally forming the dummy via hole H_vd may be minimized.

However, this is merely an example, and the dummy via hole H_vd may be constructed to have a shape and size different from those of each of the functional via holes as described above. Obviously, this is within the scope of the present disclosure. Hereinafter, the present disclosure will be described based on an embodiment in which the dummy via hole H_vd is constructed to have the same shape and size as those of each of the functional via holes. However, the present disclosure is not limited thereto.

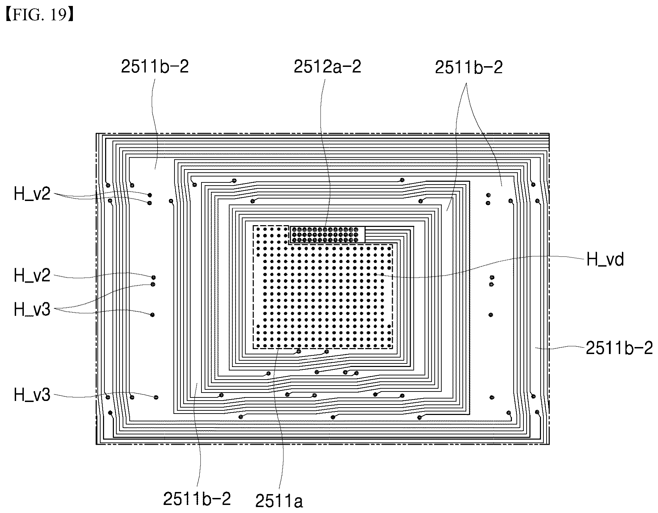

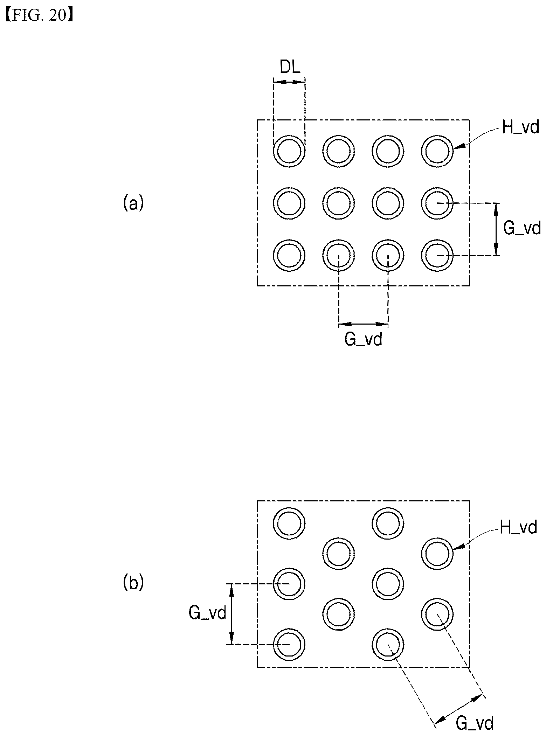

FIGS. 19 and 20 illustrate an embodiment in which a plurality of dummy via holes H_vd are provided in the non-overlapping area 2511a-2 of the second central inner area 2511a of the working coil pattern 2512 constituting a specific burner 2511.

The configuration as described below with respect to the dummy via hole H_vd may be applied to each of the non-overlapping area 2511b-2 of the inter-turn area 2511b and the non-overlapping area 2511c-2 of the inter-coil area 2511c in the same manner, unless otherwise specified.

As illustrated in FIG. 19, the plurality of dummy via holes H_vd may be arranged in a lattice shape and be disposed in the non-overlapping area 2511a-2 of the second central inner area 2511a when viewed from the top plate 21.

In FIG. 19, a portion of the second central inner area 2511a free of the dummy via hole H_vd and close to a left edge and a right edge is the overlapping area 2511a-1, and particularly, overlaps the sensing coil pattern 2514 in the vertical direction.

When, as in the present embodiment, the working coil pattern 2512 is wound in the rectangular spiral shape, the second central inner area 2511a having a substantially rectangular shape may be defined inside the working coil pattern 2512.

In consideration of the shape of the second central inner area 2511a, the individual dummy via holes H_vd may be linearly arranged in a direction parallel to the extension direction of the working coil pattern 2512. Accordingly, the plurality of dummy via holes H_vd may be arranged in the lattice shape and disposed in the second central inner area 2511a.

In addition, because the dummy via holes H_vd are arranged in the lattice shape as described above, spacings between the adjacent dummy via holes H_vd may be maintained to be approximately uniform, and the plurality of dummy via holes H_vd may be evenly arranged in the non-overlapping area 2511a-2 of the second central inner area 2511a as a whole.

In this regard, the plurality of dummy via holes H_vd may be arranged in a rectangular shape as shown in FIG. 20(a), or may be arranged in a hexagonal lattice manner as shown in FIG. 20(b).

As described above, the plurality of dummy via holes H_vd are arranged in a quadrilateral lattice manner or a hexagonal lattice manner, such that horizontal spacings G_vd between the centers of the adjacent dummy via holes H_vd may be maintained to be approximately equal to each other.

More specifically, when, as shown in (a) in FIG. 20, the plurality of dummy via holes H_vd are arranged in the quadrilateral lattice manner, the front-rear spacings and the left-right spacings between the centers of the adjacent dummy via holes H_vd may be maintained to be equal to each other, while a diagonal spacing therebetween may be larger than each of the front-rear spacing and the left-right spacing. Accordingly, the plurality of dummy via holes H_vd may be arranged in a fairly dense state.

Accordingly, the arrangement of the dummy via holes H_vd in the quadrilateral lattice manner may be considered to be suitable for an area in which the rigidity of the first coil circuit board module 251 should be reinforced to be greater or an area in which the greatest heat generation is expected to occur, such as the central area of the working coil pattern 2512.

In addition, when, as shown in (b) in FIG. 20, the plurality of dummy via holes H_vd are arranged in a hexagonal lattice manner, the front-rear spacing, the left-right spacings and the diagonal spacings between the centers of the adjacent dummy via holes H_vd may be approximately equal to each other. Accordingly, the plurality of dummy via holes H_vd may be arranged in a relatively low dense state than the arrangement thereof in the quadrilateral lattice manner may be.

Therefore, the arrangement of the dummy via holes in the hexagonal lattice manner may be considered to be suitable for an area where the rigidity of the first coil circuit board module 251 is relatively not insufficient, or an area where heat generation is not expected to be great, such as an area close to the working coil pattern 2512 in the horizontal direction

When the plurality of dummy via holes H_vd are arranged in the lattice manner as described above, the horizontal spacing between the centers of the adjacent dummy via holes H_vd needs to be larger than each of an outer diameter of a top pad H_vd2 constituting the dummy via hole H_vd and an outer diameter of a bottom pad H_vd3 constituting the dummy via hole H_vd.

This is to prevent damage to the adjacent dummy via hole that may occur when the process of machining the individual dummy via holes H_vd interferes with the dummy via hole H_vd adjacent thereto.

In addition, this is devised in consideration of the possibility that the rigidity of the first coil circuit board module 251 may be rather lowered when the plurality of dummy via holes H_vd are arranged in an excessively close proximity.

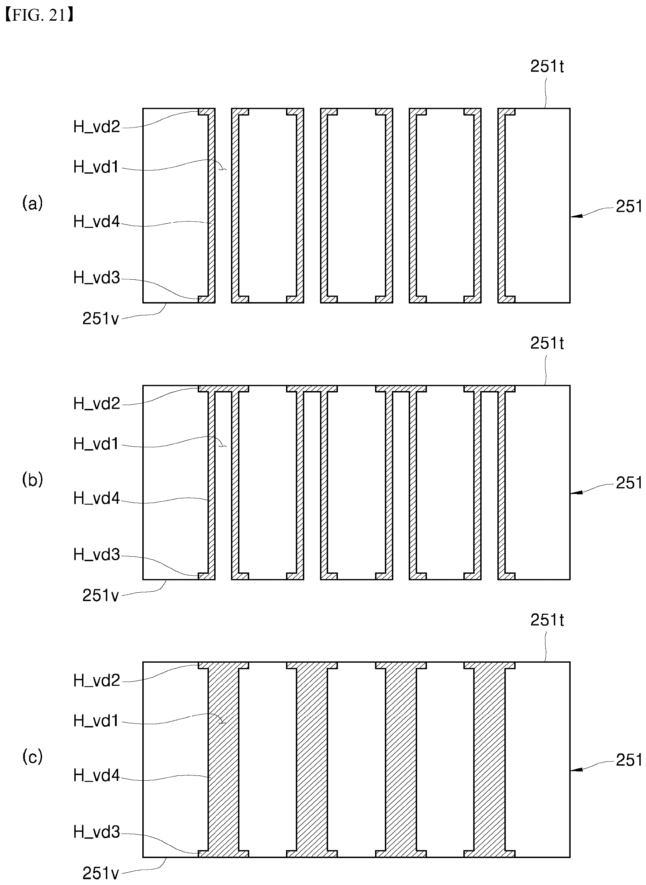

FIG. 21 shows a vertical cross-sectional shape of the dummy via hole H_vd shown in FIG. 20.

In the similar manner to the above-described functional via holes, the example dummy via hole H_vd may include the top pad H_vd2 formed at the upper end surface 251t of the first coil circuit board module 251, the bottom pad H_vd3 formed at the lower end surface 251v of the first coil circuit board module 251, and an inner conductor H_vd4 electrically connecting the top pad H_vd2 and the bottom pad H_vd3 to each other and extending along a through-hole H_vd1 of the first coil circuit board module 251.

In the similar manner to the functional via hole VH, each of the top pad H_vd2 and the bottom pad H_vd3 of the dummy via hole H_vd may be formed in a disk shape, and an upper end and a lower end of the inner conductor H_vd4 may be integrally connected to the top pad H_vd2 and the bottom pad H_vd3, respectively and thus the inner conductor H_vd4 may be formed in a cylindrical shape.

In addition, in the similar manner to the functional via hole VH, each of the top pad H_vd2, the bottom pad H_vd3, and the inner conductor H_vd4 constituting the dummy via hole H_vd may be formed by chemically and physically depositing a conductive metal material to form a thin film.

Accordingly, since the dummy via hole H_vd made of a metal material having a strength greater than that of the electrical insulating material made of the prepreg is disposed in the second central inner area 2511a so as to extend along the vertical direction, the dummy via hole H_vd may function as a skeleton for reinforcing the vertical rigidity of the first coil circuit board module 251.

Accordingly, the strength of the non-overlapping area 2511a-2 of the second central inner area 2511a may be significantly improved, and thermal deformation due to heat generation of the working coil pattern 2512 may be effectively prevented.

In addition, since the dummy via hole H_vd is made of a metal material having higher thermal conductivity than that of the electrical insulating material, the dummy via hole H_vd may function as a heat sink that absorbs and transfer the heat generated from the working coil pattern 2512.

Thus, the heat generated from the working coil pattern 2512 may be efficiently conducted to the low temperature side, and overheating of the second central inner area 2511a may be effectively suppressed.

As shown in (a) in FIG. 21, the dummy via hole H_vd may be provided in the form of a through-via in which a through-hole H_vd1 is formed radially and inwardly of the inner conductor H_vd4 and extends from the upper end surface 251t to the lower end surface 251v of the first coil circuit board module 251 and is entirely open and hollow.

As described above, an upper space on top of the upper end surface 251t of the first coil circuit board module 251 and a lower space under the lower end surface 251v of the first coil circuit board module 251 may communicate with each other through the through-hole H_vd1 that is entirely opened.

That is, the through-hole H_vd 1 of the through via-type dummy via hole H_vd may function as a ventilation hole that allows the upper space on top of the upper end surface 251t of the first coil circuit board module 251 and the lower space under the lower end surface 251v of the first coil circuit board module 251 to communicate with each other.

Therefore, through the through-hole H_vd1 functioning as the ventilation hole, high-temperature air generated in the upper space of the second central inner area 2511a may be discharged to the lower space thereof, and relatively low-temperature air existing in the lower space may be effectively introduced into the upper area. Accordingly, overheating of the first coil circuit board module 251 is additionally prevented.

As shown in (b) and (c) in FIG. 21, the dummy via hole H_vd may be provided in a form of a blind via in which the through-hole H_vd1 formed radially inwardly of the inner conductor H_vd4 is at least partially blocked.

(b) in FIG. 21 illustrates an embodiment in which the top pad H_vd2 becomes a blind via in which the through-hole H_vd1 is closed, and (c) in FIG. 21 illustrates an embodiment in which the through-hole H_vd1 is entirely filled with a conductor to become a blind via formed in a solid state.

When the dummy via hole H_vd is formed in the blind via as in the embodiment, the through-hole H_vd1 is partially or entirely blocked and thus cannot function as a ventilation hole.

However, as the through-hole H_vd1 is at least partially filled with the conductor, it is possible to expect an effect that the rigidity and thermal conductivity of the dummy via hole H_vd may be increased compared to the through-via as shown in (a) in FIG. 21,

Although not shown in FIG. 21, as will be described below, the dummy via hole H_vd may be provided in the form of a buried via that is entirely buried in the first coil circuit board module 251.

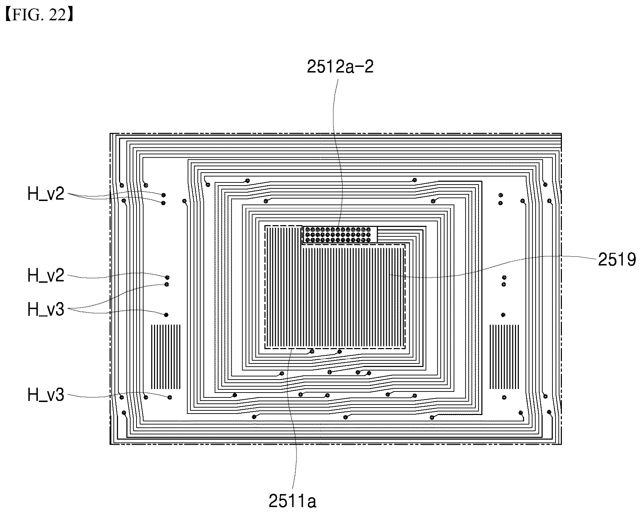

FIGS. 22 to 24 illustrate a configuration in which the dummy pattern 2519 is formed in the first coil circuit board module 251 according to a second embodiment of the present disclosure.

In a similar manner to the dummy via hole H_vd as described above, the at least one pattern 2519 may be formed in each of the non-overlapping areas 2511a-2, 2511b-2, and 2511c-2 in a state of being electrically insulated from other patterns such as the working coil pattern 2512 and the sensing coil pattern 2514 in order to maximally suppress thermal deformation due to a decrease in rigidity of the first coil circuit board module 251 and to reduce an increase in the manufacturing cost.

In that, as described above, the at least pattern 2519 provided in each of the non-overlapping areas 2511a-2, 2511b-2, and 2511c-2 is formed in a state of being electrically insulated from other patterns, and does not have the purpose of power supply or signal transmission, the at least pattern 2519 may be referred to as the dummy pattern 2519.Hereinafter, at least one pattern provided in each of the non-overlapping areas 2511a-2, 2511b-2, and 2511c-2 will be referred to as the dummy pattern 2519.

Since the dummy pattern 2519 is disposed in the non-overlapping area 2511a-2 of the first coil circuit board module 251, the dummy pattern 2519 may be disposed not to contact or overlap other patterns including the working coil pattern 2512 in the vertical direction.

Accordingly, when viewed from the top plate 21, the dummy pattern 2519 may be disposed to entirely belong to each of the non-overlapping area 2511a-2 of the second central inner area 2511a, the non-overlapping area 2511c-2 of the coiler area 2511c, and the non-overlapping area 2511b-2 of the turn-on area 2511b.

In addition, in a similar manner to the dummy via hole H_vd as described above, the dummy pattern 2519 is disposed not to contact or overlap other patterns including the working coil pattern 2512 in the vertical direction, respective shapes and sizes of the non-overlapping area 2511a-2 of the second central inner area 2511a, the non-overlapping area 2511c-2 of the inter-coil area 2511c, and the non-overlapping area 2511b-2 of the inter-turn area 2511b may be different from each other or irregularly based on positions thereof. Thus, the shape in which the dummy patterns 2519 may be arranged in the non-overlapping area 2511a-2 of the second central inner area 2511a, the shape in which the dummy patterns 2519 may be arranged in the non-overlapping area 2511c-2 of the inter-coil area 251 1c, and the shape in which the dummy patterns 2519 may be arranged in the non-overlapping area 2511b-2 of the inter-turn area 2511b may be different from each other or irregularly based on positions thereof.

As described above, according to the present disclosure, each of the working coil pattern 2512 and the sensing coil pattern 2514 is arranged in a multi-layered structure.

The dummy pattern 2519 may be constructed to have the same size as that of each of the working coil pattern 2512 and the sensing coil pattern 2514.

Therefore, the dummy pattern 2519 may be subject to the same machining process as a machining process for forming the functional pattern such as the working coil pattern 2512 and the sensing coil pattern 2514 without changing the setting of the manufacturing equipment for forming the functional pattern such as the working coil pattern 2512 and the sensing coil pattern 2514 and changing the manufacturing equipment. Thus, an increase in the manufacturing cost and manufacturing time for additionally forming the dummy pattern 2519 may be minimized.

However, this is merely an example, and the dummy pattern 2519 may be constructed to have a different size from sizes of the functional patterns as described above, and this will naturally fall within the scope of the present disclosure. Hereinafter, the present disclosure will be described based on an embodiment in which the dummy pattern 2519 is constructed to have the same size as that of each of the functional patterns. However, the present disclosure is not limited thereto.

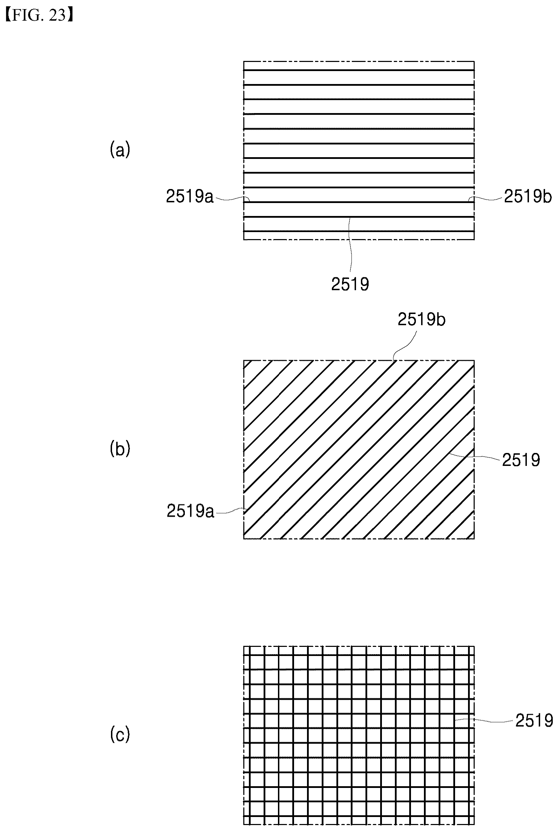

FIGS. 22 and 23 illustrate an embodiment in which a plurality of dummy patterns 2519 are provided in the non-overlapping area 2511a-2 of the second central inner area 2511a of the working coil pattern 2512 forming a specific burner 2511.

The configuration described below with respect to the dummy pattern 2519 may be applied to each of the non-overlapping area 2511b-2 of the inter-turn area 2511b and the non-overlapping area 2511c-2 of the inter-coil area 2511c in the same manner, unless otherwise specified.

As illustrated in FIG. 22, each of the plurality of dummy patterns 2519 may extend in a direction parallel to or intersecting the winding direction of the working coil pattern 2512 in the non-overlapping area 2511a-2 of the second central inner area 2511a when viewed from the top plate 21. Accordingly, the plurality of dummy patterns 2519 may function as a skeleton for reinforcing the rigidity of the first coil circuit board module 251 in the left-right direction.

As in the embodiment, when the working coil pattern 2512 is wound in the rectangular spiral shape, the second central inner area 2511a having a substantially rectangular shape may be formed inside the working coil pattern 2512.

In consideration of the shape of the second central inner area 2511a, the individual dummy patterns 2519 may extend linearly along the front-rear direction or the left-right direction and along a direction parallel to or intersecting the extension direction of the working coil pattern 2512.

In this regard, as shown in (a) in FIG. 23, the plurality of dummy patterns 2519 may linearly extend along the left-right direction and in a parallel manner to each other and may be arranged so as to be spaced from each other. As shown in (b) in FIG. 23, the plurality of dummy patterns 2519 may linearly extend along the diagonal direction and in a parallel manner to each other and may be arranged so as to be spaced from each other. As shown in (c) in FIG. 23, the plurality of dummy patterns 2519 may linearly extend along the front-rear direction and along the left-right direction and may be arranged so as to be spaced from each other in each of the front-rear direction and along the left-right direction such that the plurality of dummy patterns 2519 may intersect with each other.

The configuration in which the dummy patterns 2519 are arranged to intersect each other as shown in (c) in FIG. 23 may be considered to be suitable for an area in which the rigidity of the first coil circuit board module 251 should be reinforced to be greater or an area in which the greatest heat generation is expected to occur, such as a central area of the working coil pattern 2512.

In addition, the arrangement of the dummy patterns 2519 as shown in (a) and (b) in FIG. 23 may be considered to be suitable for an area where the rigidity of the first coil circuit board module 251 is not relatively insufficient or an area where heat generation is not expected to be large, such as an area close to the working coil pattern 2512 in the horizontal direction.

Although (a) and (b) in FIG. 23 illustrate a configuration in which the individual dummy patterns 2519 extend in a parallel manner to each other and are arranged so as to be spaced from each other, the present disclosure is not limited thereto. In another example, the individual dummy patterns 2519 may be connected to each other into a single pattern. That is, the dummy pattern 2519 may be constructed as one continuous pattern by connecting respective adjacent ends of the dummy patterns 2519 disposed adjacent to each other to each other. It will be appreciated that such a modified example naturally falls within the scope of the present disclosure.

As described above, according to the present disclosure, the working coil pattern 2512 is composed of the plurality of layers vertically arranged.

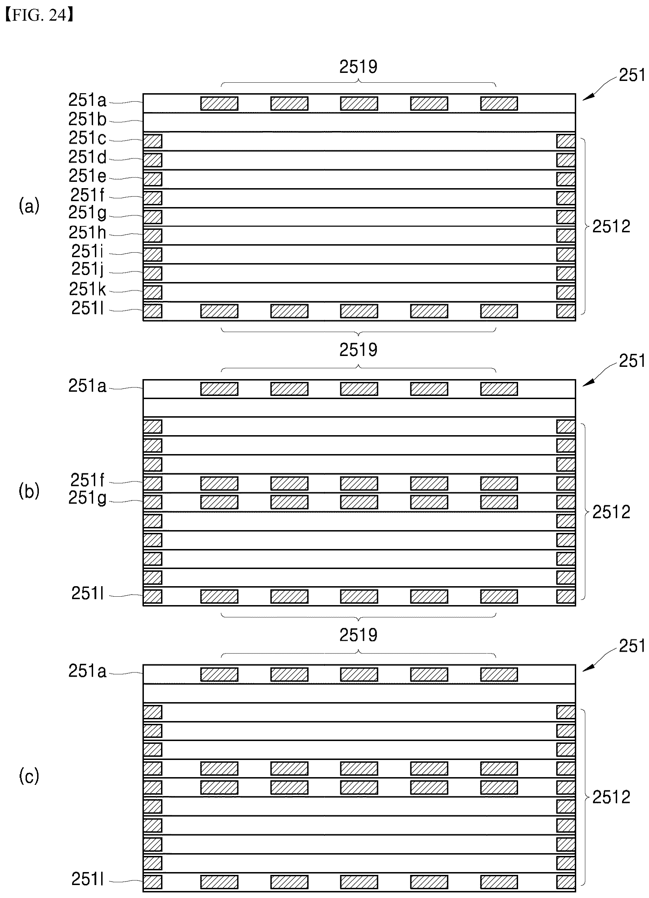

Correspondingly, the dummy pattern 2519 according to a second embodiment of the present disclosure may have a multi-layer structure as shown in FIG. 24.

(a) in FIG. 24 illustrates a configuration in which the dummy patterns 2519 are formed only in the first layer 251a constituting the upper end surface 251t of the first coil circuit board module 251 including the total of 12 layers and in the twelfth layer 2511 constituting the lower end surface 251v of the first coil circuit board module 251 according to the present embodiment.

As described above, the configuration in which the dummy pattern 2519 is formed only in the twelfth layer 2511 constituting the lower end surface 251v of the first coil circuit board module 251 may be considered to be suitable for an area in which the rigidity of the first coil circuit board module 251 is not relatively insufficient or an area in which heat generation is not expected to be large, such as an area close to the working coil pattern 2512 in the horizontal direction.

Furthermore, when the number of layers of the working coil pattern 2512 is five or smaller, which is smaller than that in the present embodiment, a modification of the first coil circuit board module 251 may be made such that the dummy pattern 2519 is formed only in one of the upper end surface 251t and the lower end surface 251v, particularly, the first layer 251a that is more affected by the temperature of each of the container and the top plate 21.

In addition, as illustrated in (b) in FIG. 24, the dummy patterns 2519 may be additionally disposed in the sixth layer 251a and the seventh layer 251l as the inner layers in addition to the first layer 251f and the twelfth layer 251g.

The embodiment shown in (b) in FIG. 24 may be considered to be suitable for an area in which the rigidity of the first coil circuit board module 251 is relatively insufficient or an area in which heat generation is expected to be greater, compared to the embodiment of (b) in FIG. 24.

Further, as shown in (c) in FIG. 24, the dummy patterns 2519 may be disposed in all of the first layer 251a to twelfth layer 2511.

The embodiment as shown in (c) in FIG. 24 may be considered to be suitable for an area in which the rigidity of the first coil circuit board module 251 should be greatly reinforced or an area in which heat generation is expected to be very greater, compared to the embodiments of (a) and (b) in FIG. 24.

In the embodiments as illustrated in FIG. 24, the respective dummy patterns 2519 disposed in respective layers are positioned so as to overlap each other in the vertical direction. However, the present disclosure is not limited thereto. Alternatively, the respective dummy patterns 2519 disposed in respective layers may be positioned so as to non-overlap each other in the vertical direction or may be positioned such that an overlapping area may be small. It will be appreciated that such a modified example naturally falls within the scope of the present disclosure.

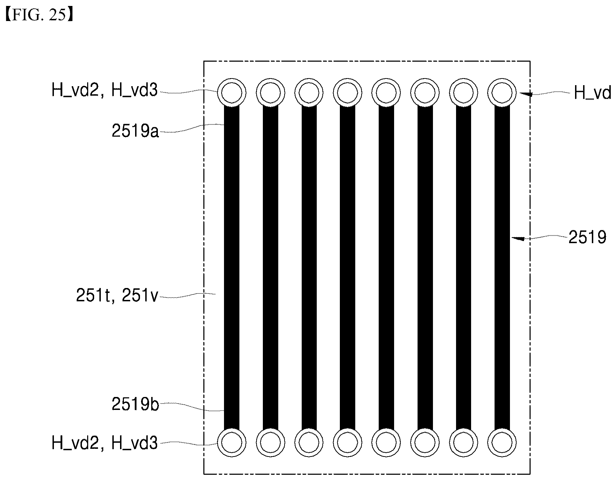

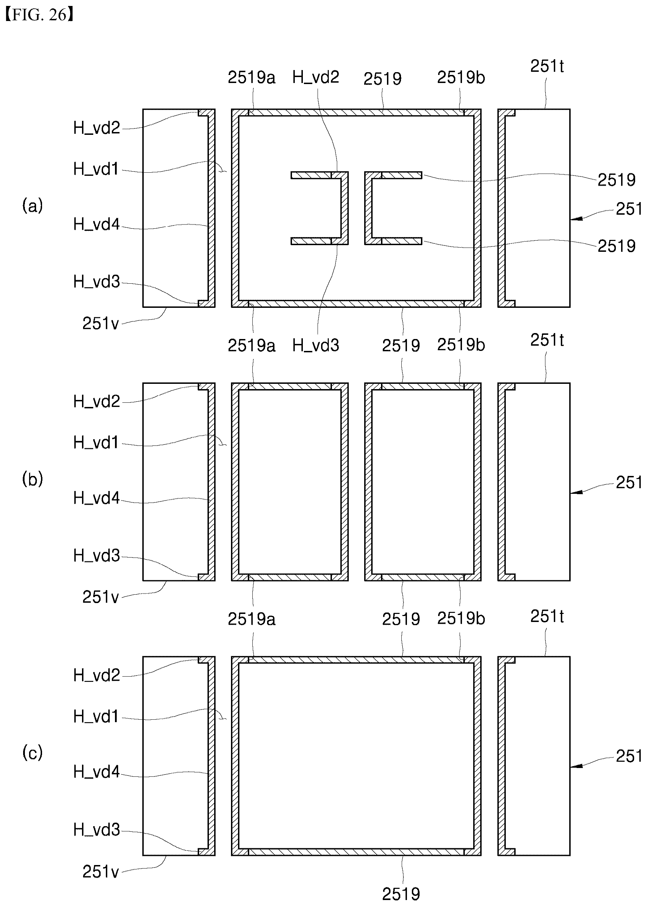

FIGS. 25 and 26 illustrate a configuration in which the dummy via hole H_vd and the dummy pattern 2519 are formed together in the first coil circuit board module 251 according to a third embodiment of the present disclosure.

In the above-described first embodiment, only the dummy via hole H_vd is provided in the second central inner area 2511a of the first coil circuit board module 251, and in the second embodiment, only the dummy pattern 2519 is provided in the second central inner area 2511a of the first coil circuit board module 251. However, in this embodiment, the dummy via hole H_vd and the dummy pattern 2519 may be provided together in the second central inner area 2511a of the first coil circuit board module 251.

That is, the above-described embodiments have been described based on the first coil circuit board module 251 having a total of 12 layers. However, when the first coil circuit board module 251 has a multi-layer structure in which the number of layers is larger than 12, the rigidity of the second central inner area 2511a may not be sufficiently supplemented only by the dummy via hole H_vd and the dummy pattern 2519, or the overheating suppressing effect may be insufficient.

As, as described above, the number of the layers of the first coil circuit board module 251 is further increased, the rigidity of the second central inner area 2511a should be additionally reinforced or heat generation efficiency should be additionally improved. To this end, as shown in FIG. 25, the dummy via hole H_vd and the dummy pattern 2519 may be provided together in the second central inner area 2511a.

In a similar manner to the dummy pattern 2519 of the second embodiment described above, the dummy patterns 2519 may extend linearly and be arranged so as to be spaced from each other by an equal spacing.

In this case, as illustrated, a first end 2519a and a second end 2519b of each dummy pattern 2519 may be physically connected to the top pad H_vd2 or the bottom pad H_vd3 of the dummy via hole H_vd and thus may be integrated therewith.

That is, the dummy pattern 2519 disposed in the upper end surface 251t of the first coil circuit board module 251 may be constructed such that both the first end 2519a and the second end 2519b thereof are physically connected to the top pad H_vd2 of the dummy via hole H_vd.

Alternatively, the dummy pattern 2519 disposed in the lower end surface 251v of the first coil circuit board module 251 may be constructed such that both the first end 2519a and the second end 2519b thereof are physically connected to the bottom pad H_vd3 of the dummy via hole H_vd.

In addition, although not shown, when the dummy pattern 2519 is disposed in the inner layer between the upper end surface 251t and the lower end surface 251v of the first coil circuit board module 251, both the first end 2519a and the second end 2519b of the dummy pattern 2519 may be connected to the inner conductor H_vd4 of the dummy via hole H_vd.

As described above, the dummy pattern 2519 is disposed between the pair of dummy via holes H_vd spaced apart from each other and the pair of dummy via holes H_vd are physically connected to each other via the dummy pattern 2519, such that the rigidity reinforcement effect and the heat transfer efficiency may be further improved compared to the configuration in which the dummy pattern 2519 and the dummy via hole H_vd are physically isolated from each other.

However, the configuration shown in FIG. 25 is merely an example. It will be appreciated that the configuration in which the dummy via hole H_vd and the dummy pattern 2519 are not connected to each other is naturally within the scope of the present disclosure. Hereinafter, the configuration in which the top pad H_vd2 and the bottom pad H_vd3 of the dummy via hole H_vd are connected to the first end 2519a or the second end 2519b of the dummy pattern 2519 will be described by way of example.

FIG. 26 illustrates connection structures between the dummy via hole H_vd and the dummy pattern 2519.

That is, as shown in (a) in FIG. 26, the top pads H_vd2 or the bottom pads H_vd3 of the pair of through via-type dummy via holes H_vd may be connected to each other via the dummy pattern 2519.

In the illustrated embodiment, the top pads H_vd2 of the pair of through via-type dummy via holes H_vd are connected to each other via the top dummy pattern 2519, while the bottom pads H_vd3 of the pair of through via-type dummy via holes H_vd are connected to each other via the bottom dummy pattern 2519. Alternatively, only the top pads H_vd2 or the bottom pads H_vd3 of the pair of dummy via holes H_vd may be connected to each other via the dummy pattern 2519.

In addition, when, as illustrated, the dummy via hole H_vd is provided in the form of the buried via which is buried in the first coil circuit board module 251, the dummy pattern 2519 may be connected to the top pad H_vd2 or the bottom pad H_vd3 of the buried via.

In addition, as shown in (b) in FIG. 26, two or more dummy patterns 2519 may be connected to the top pad H_vd2 or the bottom pad H_vd3 of one dummy via hole H_vd.

In addition, as shown in (c) FIG. 26, the first end 2519a and the second end 2519b of the dummy pattern 2519 may be connected to each of the top pad H_vd2 and the bottom pad H_vd3 of the dummy via hole H_vd provided in the form of a blind via.

However, the connection structure between the dummy via hole H_vd and the dummy pattern 2519 as described above is merely an example.

The connection structures between the dummy via hole H_vd and the dummy pattern 2519 may be variously modified or combined with each other in consideration of various factors such as the number of layers of the first coil circuit board module 251, the thickness in the vertical direction thereof, the area size of the second central inner area 2511a thereof, the shape of the second central inner area 2511a, etc. This modification may be considered to be within the scope of the present disclosure.

Although the present disclosure has been described above with reference to the drawings illustrated with respect to the present disclosure, the present disclosure is not limited to the embodiments and drawings disclosed in the present disclosure. It is obvious that various modifications may be made thereto by a person skilled in the art within the scope of the technical idea of the present disclosure. In addition, even though the effects according to the configuration of the present disclosure are not explicitly described while illustrating the embodiment of the present disclosure, it is obvious that the predictable effect therefrom should also be recognized.

## Claims

1. A cooking appliance comprising:
a top plate on which a container is seated; and
a heater configured to receive electric power to generate a magnetic field to heat the container,
wherein the heater includes a coil circuit board module including a working coil pattern generating the magnetic field,
wherein the coil circuit board module further includes a dummy via hole or a dummy pattern formed therein, wherein the dummy via hole or the dummy pattern is electrically insulated from the working coil pattern.

2. The cooking appliance of claim 1, wherein the coil circuit board module further includes a sensing coil pattern for sensing whether the container is seated,
wherein each of the dummy via hole and the dummy pattern is positioned so as to be electrically insulated from the sensing coil pattern.

3. The cooking appliance of claim 1, wherein a central inner area is defined inwardly of the working coil pattern in a horizontal direction,
wherein the dummy via hole and the dummy pattern are positioned to be within the central inner area when viewed from the top plate.

4. The cooking appliance of claim 1, wherein the working coil pattern is wound spirally to form a plurality of turns,
wherein an inter-turn area is defined between turns constituting the working coil pattern and disposed adjacent to each other in a horizontal direction,
wherein the dummy via hole and the dummy pattern are disposed to be within the inter-turn area when viewed from the top plate.

5. The cooking appliance of claim 1, wherein the working coil pattern includes a plurality of working coil patterns,
wherein an inter-coil area is defined between the working coil patterns adjacent to each other in a horizontal direction among the plurality of working coil patterns,
wherein the dummy via hole and the dummy pattern are disposed to be within the inter-coil area when viewed from the top plate.

6. The cooking appliance of claim 1, wherein the dummy via hole includes a plurality of dummy via holes,
wherein the plurality of dummy via holes are arranged in a lattice shape when viewed from the top plate.

7. The cooking appliance of claim 6, wherein the lattice shape is a quadrilateral lattice shape or a hexagonal lattice shape.

8. The cooking appliance of claim 6, wherein each of the plurality of dummy via holes includes:
a top pad formed in an upper surface of the coil circuit board module; and
a bottom pad electrically connected to the top pad and formed in a lower end surface of the coil circuit board module,
wherein a horizontal spacing between centers of a pair of via holes adjacent to each other among the plurality of dummy via holes is greater than each of an outer diameter of the top pad and an outer diameter of the bottom pad.

9. The cooking appliance of claim 1, wherein the dummy via hole extends along a through-hole extending through the coil circuit board module in a vertical direction from an upper end surface of the coil circuit board module to a lower end surface of the coil circuit board module.

10. The cooking appliance of claim 9, wherein the dummy via hole includes:
a top pad formed in an upper surface of the coil circuit board module;
a bottom pad formed in a lower end surface of the coil circuit board module; and
an inner conductor electrically connecting the top pad and the bottom pad to each other and extending along the through-hole.

11. The cooking appliance of claim 10, wherein the dummy via hole is formed in a hollow state from the top pad to the bottom pad.

12. The cooking appliance of claim 10, wherein the dummy via hole is formed in a solid state from the top pad to the bottom pad.

13. The cooking appliance of claim 10, wherein the dummy via hole is formed in a state in which at least one of the top pad or the bottom pad closes the through-hole.

14. The cooking appliance of claim 1, wherein the dummy pattern extends in a direction parallel to a winding direction of the working coil pattern or in a direction intersecting the winding direction of the working coil pattern.

15. The cooking appliance of claim 1, wherein the dummy pattern includes a plurality of dummy patterns,
wherein the plurality of dummy patterns are arranged so as to be spaced from each other.

16. The cooking appliance of claim 1, wherein the coil circuit board module includes a plurality of working coil patterns arranged in a plurality of layered structures, and the plurality of layered structures are integrally formed with each other.

17. The cooking appliance of claim 19, wherein the dummy pattern includes a plurality of dummy patterns,
wherein at least some of the plurality of dummy patterns are disposed in an upper end surface or a lower end surface of the coil circuit board module.

18. The cooking appliance of claim 1, wherein the coil circuit board module includes a plurality of working coil patterns arranged in a plurality of layered structures along a vertical direction,
wherein the others of the plurality of dummy patterns are disposed in an inner layer of the plurality of layered structures.

19. The cooking appliance of claim 1, wherein both the dummy via hole and the dummy pattern are disposed in the coil circuit board module,
wherein one end or the other end of the dummy pattern is connected to the dummy via hole.

20. A home appliance comprising:
a top plate with which an object is in contact; and
a coil circuit board module disposed under the top plate and including a working coil pattern for heating the object,
wherein the coil circuit board module further includes a dummy metal portion electrically insulated from the working coil pattern.
